# FASCICULE DE BREVET EUROPEEN

(11) **EP 0 258 141 B1**
(45) Date de publication et mention de la délivrance du brevet: **18.11.1993**
(21) Numéro de dépôt: 87401908.6
(22) Date de dépôt: 19.08.1987
(51) Int. Cl.: H01L 27/10, H01L 21/82

(54) **Circuit intégré MIS tel qu'une cellule de mémoire EPROM et son procédé de fabrication**
MIS integrierte Schaltung, wie eine EPROM-Speicherzelle, und Verfahren zu deren Herstellung
MIS integrated circuit such as an EPROM memory cell, and method of making the same

(30) Priorité: 21.08.1986 FR 8611947
(43) Date de publication de la demande: 02.03.1988
(73) Titulaire: COMMISSARIAT A L'ENERGIE ATOMIQUE, 75015 Paris Cédex 15 (FR)
(72) Inventeur: Jeuch, Pierre, F-38170 Seyssins (FR); Heitzmann, Michel, F-38190 Crolles (FR)
(74) Mandataire: Mongrédien, André

(56) Documents cités:
- EP-A- 0 109 853
- DE-A- 3 103 143
- FR-A- 2 523 354
- GB-A- 2 060 999

## Description

La présente invention a pour objet un circuit intégré MIS ainsi que son procédé de fabrication. Elle s'applique en particulier dans le domaine de la fabrication de circuits mémoires intégrés du type MOS ou CMOS et notamment aux mémoires non volatiles du type EPROM, EEPROM, ROM.

Une mémoire intégrée est un circuit intégré comprennant une partie mémoire proprement dite, appelée cellule mémoire, formée de plusieurs points mémoires connectés électriquement entre eux, et des circuits périphériques servant à commander les points mémoires.

L'invention a trait uniquement à la partie mémoire proprement dite et à sa fabrication.

Les cellules mémoires EPROM à grille flottante les plus modernes, permettant la mémorisation de 10⁶ éléments binaires, présentent aujourd'hui des surfaces de 20 à 25 µm² dans une technologie de 1,2 µm, c'est-à-dire dans laquelle les bandes et les espaces les plus petits mesurent 1,2 µm. La surface d'une mémoire est donc d'environ 14 à 17 fois celle du carré élémentaire de la lithographie (1200 x 1200 nm²).

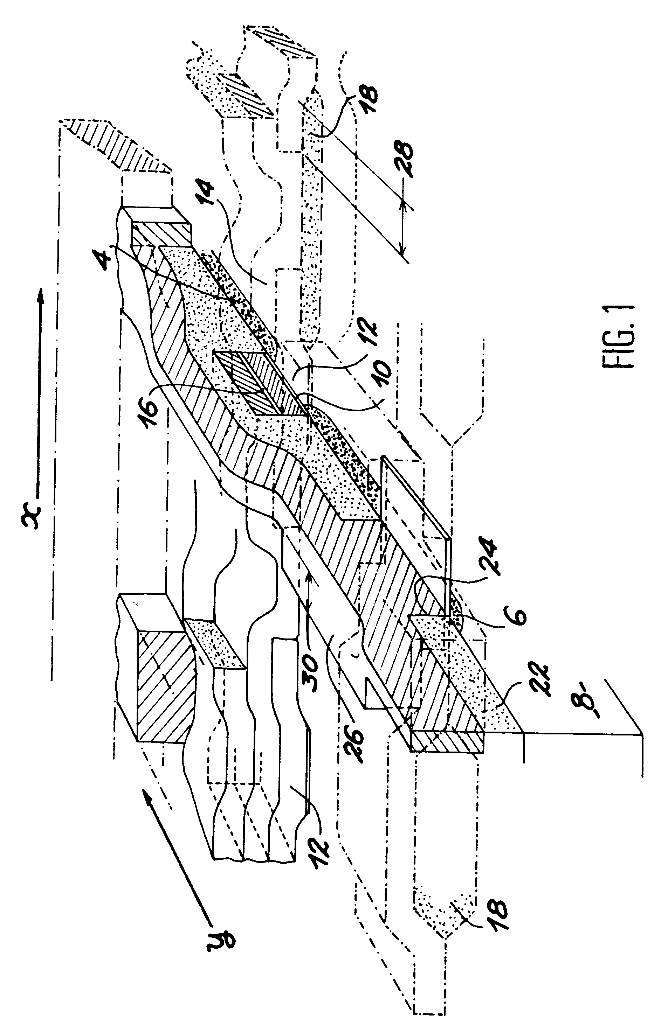

Sur la figure 1, on a représenté schématiquement en perspective une cellule mémoire EPROM à grille flottante connue. Ce type de mémoire est notamment décrit dans le document IEDM-84, p. 460-462 de Jih Lien "A high performances CMOS process for the next generation EPROM".

Comme représenté sur la figure 1, un point mémoire est formé d'un transistor comprenant une source 4 et un drain 6 réalisés dans un substrat 8 semiconducteur monocristallin en silicium ; la source et le drain présentent des conductivités inverses de celles du substrat.

Le transistor comprend en outre un isolant de grille 10, généralement en oxyde de silicium, sur lequel sont empilées une première grille 12, une seconde grille 14, généralement réalisées en silicium polycristallin dopé au phosphore. Ces deux grilles sont séparées par une fine couche d'isolant 16, généralement en oxyde de silicium.

La première grille 12 est une grille flottante et la seconde grille 14 est la grille de commande du point mémoire.

Ce point mémoire est isolé électriquement, au moyen d'un oxyde de champ 18 réalisé par oxydation localisée et superficielle du substrat, des autres points mémoires ainsi que des circuits périphériques de commande de ce point mémoire.

L'ensemble d'une cellule mémoire est recouvert d'une couche épaisse isolante 22, généralement en oxyde de silicium dans laquelle sont réalisés les trous de contact électriques des sources et des drains tels que 24. Les connexions électriques entre les sources et les drains des différents points mémoires et/ou les différents circuits périphériques de commande sont assurées par une couche conductrice 26, généralement en aluminium, déposée sur la couche isolante 24 et gravée de façon appropriée.

Les connexions électriques entre les grilles de commande des différents points mémoires sont définies en même temps que les grilles de commande 14 et dans la même couche de silicium polycristallin. Elles sont donc situées au-dessous des connexions des sources entre elles et des drains entre eux.

De plus en plus, on cherche à diminuer la dimension des circuits intégrés, et en particulier des mémoires, en vue d'augmenter leur densité d'intégration. Malheureusement, dans les mémoires EPROM actuellement connues deux facteurs limitent la réduction des dimensions de la cellule mémoire.

Le premier facteur est le débordement 28 de la grille flottante 12 au-dessus de l'oxyde de champ 18 ; ce débordement est nécessaire à cause de l'imprécision de superposition des différentes couches constituant les points mémoires et des masques de lithographie, nécessaires pour la gravure des différentes couches. Ce débordement est dans la direction X des lignes de mots (ou connexions des grilles) de la cellule mémoire, direction qui est perpendiculaire à celles des canaux des points mémoires. Dans les circuits MIS, le débordement de la grille unique des transistors au-dessus de l'oxyde de champ existe aussi.

Le second facteur, qui est dans la direction Y des lignes des éléments binaires et parallèle à la direction des canaux des points mémoires, est la nécessité de prévoir autour des trous de contact de la ligne d'éléments binaires, c'est-à-dire autour des trous de contacts des drains des points mémoires, des gardes isolantes 30. Ce second facteur de limitation existe aussi dans les mémoires EEPROM et ROM et de façon générale dans tout circuit intégré MIS.

En particulier, dans les circuits intégrés à grilles de commande en silicium polycristallin, les drains et les sources des composants sont auto-positionnés par rapport à la grille grâce à une implantation ionique utilisant les grilles comme masque. Il en résulte que toute intersection d'une bande de silicium polycristallin avec une zone active (ou dopée du substrat) produit un transistor MIS. Aussi, il n'est pas possible de croiser une bande "diffusée" (n+ ou p+) dans le substrat jouant le rôle de connexion de sources et de drains avec une connexion de grilles en silicium polycristallin.

Pour réaliser de tels croisements, il faut utiliser une couche d'isolation et un niveau de lignes conductrices en métal sur cette couche isolante, ce qui prend beaucoup de place du fait de la nécessité de réaliser des prises de contact dans cette couche.

Par ailleurs, des bandes "diffusées" dansle substrat ne peuvent constituer à elles seules des lignes d'interconnexion du fait de leur forte résistivité.

La diminution des dimensions lithographiques, ne s'accompagnant pas généralement d'une amélioration proportionnelle dans les précisions de superposition des différents niveaux, notamment de masquages lithographiques, les facteurs de limitation mentionnés ci-dessus vont être de plus en plus pénalisants pour l'augmentation de la densité d'intégration notamment des mémoires non volatiles.

Des procédés d'auto-alignement ou d'auto-positionnement évitant le débordement de la grille flottante sur l'oxyde de champ et/ou les gardes isolantes autour des trous de contact deviennent donc nécessaires pour les générations futures de mémoires non volatiles.

En plus des problèmes de densité d'intégration, les mémoires non volatiles et EPROM notamment actuellement connues nécessitent, lors de la programmation, correspondant à l'écriture, l'application de tensions élevées sur la grille de commande des points mémoires, de l'ordre de 12,5 volts, afin d'injecter les électrons chauds, engendrés près du drain, dans la grille flottante. L'utilisation de tensions de programmation aussi élevées est assez contraignante pour la conception des circuits périphériques servant à commander la cellule mémoire.

Par ailleurs, il est connu par les documents GB-A-2 060 999 et EP-A-0 109 853 des mémoires EPROM à lignes conductrices de commande croisées, ces lignes étant réalisées en même temps que les sources, drains et grilles des points mémoires. Ainsi, les lignes de commande des sources et des drains ne peuvent pas être réalisées en métal, indépendamment et directement sur les sources et drains.

La présente invention a justement pour objet un circuit intégré MIS, et son procédé de fabrication permettant en particulier de remédier aux différents inconvénients cités précédemment. Dans l'application particulière à une cellule mémoire, cette dernière présente notamment un auto-alignement ou auto-positionnement intégral de tous les éléments constitutifs de ses points mémoires, ce qui conduit à une surface de mémoire ne représentant que quatre à cinq fois la surface lithographique minimale. En outre, une cellule mémoire selon l'invention n'est pas limitée à une technologie micronique et peut être réalisée selon une technologie submicronique.

Par ailleurs, elle présente des performances électriques améliorées. En effet, le temps d'accès de la cellule, lors de la programmation, est réduit et la tension d'écriture est diminuée ; on peut notamment envisager d'utiliser la même tension pour l'écriture et la lecture, tension de l'ordre de 5 volts.

De façon générale, l'invention a pour objet un circuit MIS intégré sur un substrat semiconducteur, comportant (a) un ensemble de transistors isolés électriquement et latéralement les uns des autres, chaque transistor comprenant un premier empilement de matériaux formé d'un premier isolant, en contact avec le substrat, et d'au moins une grille au contact du premier isolant, une source et un drain formés dans le substrat de part et d'autre de l'empilement et un canal, situé dans le substrat sous ledit empilement, dont la longueur est orientée selon une première direction allant de la source au drain, (b) des premières lignes conductrices d'axe longitudinal parallèle à une seconde direction pour appliquer des premiers signaux électriques sur lesdits empilements, (c) des secondes lignes conductrices d'axe longitudinal parallèle à une troisième direction pour appliquer des seconds signaux électriques sur les drains et (d) des troisièmes lignes conductrices d'axe longitudinal parallèle à la troisième direction pour appliquer des troisièmes signaux électriques sur les sources, la seconde direction étant confondue avec la première direction et la troisième direction étant perpendiculaire à la première direction, caractérisé en ce que les secondes et troisièmes lignes conductrices sont réalisées directement sur respectivement les drains et les sources.

Dans le circuit de l'invention les lignes d'interconnexion des drains et les lignes d'interconnexion des sources servant à appliquer les signaux de commande appropriés sont réalisées directement et respectivement sur les drains et les sources, et donc au-dessous des lignes d'interconnexion des grilles contrairement à l'art antérieur. Ceci permet d'éviter les prises de contact sur les sources et les drains, par mise en oeuvre de gravure d'une couche isolante surmontant les lignes d'interconnexion des grilles et les grilles, et d'améliorer le contact électrique entre les zones actives et les lignes d'interconnexion de ces zones actives.

Bien que l'invention s'applique à tous circuits intégrés comportant plusieurs transistors MIS, elle est parfaitement bien adaptée aux mémoires non volatiles comportant une matrice de transistors MIS à grille flottante.

L'invention a donc aussi pour objet une cellule mémoire intégrée sur un substrat semiconducteur comportant (a) un ensemble de points mémoires isolés électriquement et latéralement les uns des autres, chaque point mémoire comprenant un premier empilement de matériaux formé d'un premier isolant, en contact avec le substrat, d'une première et d'une seconde grilles, séparées l'une de l'autre par un second isolant, la première grille étant au contact du premier isolant, une source et un drain formés dans le substrat de part et d'autre de l'empilement de grilles, et un canal, situé dans le substrat sous ledit empilement et dont la longueur est orientée selon une première direction allant de la source au drain, (b) des premières lignes conductrices d'axe longitudinal parallèle à une seconde direction pour appliquer des premiers signaux électriques sur lesdits empilements, (c) des secondes lignes conductrices d'axe longitudinal parallèle à une troisième direction, perpendiculaire à la seconde direction pour appliquer des seconds signaux électriques sur les drains, et (d) des troisièmes lignes conductrices d'axe longitudinal parallèle à la troisième direction pour appliquer des troisièmes signaux électriques sur les sources, la seconde direction étant confondue avec la première direction et la troisième direction étant perpendiculaire à la première direction, caractérisée en ce que les secondes et troisièmes lignes conductrices sont réalisées respectivement et directement sur les drains et les sources des points mémoires.

Autrement dit, les premières lignes conductrices, correspondant aux lignes de mots pour une cellule mémoire, sont parallèles à la longueur des transistors ou points mémoires et les secondes lignes conductrices, correspondant pour une cellule mémoire aux lignes des éléments binaires, sont perpendiculaires à la longueur des canaux des transistors. Ceci contribue à la suppression de la couche isolante dans laquelle sont définis les trous de contacts électriques des sources et des drains des transistors ou points mémoires et par conséquent des gardes isolantes autour de ces trous de contact, réduisant ainsi de façon considérable les dimensions du circuit intégré.

De préférence, les premières lignes conductrices sont réalisées en métal et indépendamment des grilles de commande (grille unique pour un transistor MIS simple ou seconde grille pour un transistor comportant une grille flottante) et donc en des matériaux différents. Ceci permet, entre autres, la réalisation de ces premières lignes conductrices aprés la réalisation des sources et des drains par implantation ionique suivie d'un recuit, et donc l'utilisation d'un métal ayant tendance à se détériorer lors du recuit comme l'aluminium.

L'utilisation de l'aluminium pour l'interconnexion des grilles de commande offre de gros avantages du fait de sa faible résistivité et de son faible coût comparé à celui des métaux réfractaires (Ti, W, Ta).

Les secondes et troisièmes lignes conductrices sont par exemple réalisées en métal ou en siliciure d'un métal réfractaire.

Dans le cas particulier de transistors grille flottante la première et la seconde grilles de ces transistors ne s'étendent pas au-dessus des isolations latérales, servant à isoler électriquement les transistors entre eux, et sont auto-alignées (ou auto-positionnées) par rapport à ces isolations, contribuant encore à la réduction des dimensions du circuit intégré MIS. De même l'unique grille de simples transistors MIS ne s'étend pas au-dessus de ces isolations.

Dans le cas particulier d'une cellule mémoire comportant des transistors à grille flottante, les performances électriques de la cellule dépendent de la valeur de la capacité de couplage entre la grille flottante et la grille de commande des points mémoires. En particulier, le rapport de cette capacité à celle définie entre la grille flottante et le substrat fixe la tension qui doit être appliquée sur la grille flottante pour une tension de grille de commande déterminée. Ceci est en particulier pénalisant lors de l'écriture dans la mémoire en imposant une tension d'écriture élevée.

Afin de réduire la tension d'écriture, la première grille ou grille flottante présente avantageusement, la forme d'un U selon une coupe parallèle à la troisième direction et donc à l'axe longitudinal des lignes de connexion des drains des points mémoires. Cette forme en U augmente notablement la surface de couplage entre les deux grilles, sans toutefois augmenter l'encombrement de la cellule.

Le couplage peut encore être augmenté en utilisant une grille flottante en forme de "cuvette" dont le fond définit le canal et dont les côtés remontent verticalement. Autrement dit la grille flottante présente selon une coupe parallèle à la troisième direction et simultanément selon une coupe parallèle à la seconde direction la forme d'un U. La grille de commande remplit et recouvre cette cuvette.

L'invention a aussi pour objet un procédé de fabrication d'un circuit intégré selon la revendication 1 sur un substrat semiconducteur comportant (a) un ensemble de transistors isolés électriquement les uns des autres par des isolations latérales, chaque transistor comprenant au moins une grille, une source et un drain situés de part et d'autre de la grille et un canal situé sous la grille, (b) des premières lignes conductrices pour appliquer des premiers signaux électriques sur les grilles, (c) des secondes lignes conductrices pour appliquer des seconds signaux électriques sur les drains, et (d) des troisièmes lignes conductrices pour appliquer des troisièmes signaux électriques sur les sources, caractérisé en ce qu'il ne comporte que trois niveaux de masquage lithographique, un premier masque pour définir simultanément la largeur des canaux ainsi que la longueur des isolations latérales, un second masque pour définir simultanément la largeur des isolations latérales ainsi que la longueur des canaux, et un troisième masque pour définir les premières lignes conductrices et en ce que les secondes et troisièmes lignes conductrices sont réalisées directement et respectivement sur les drains et sources.

En plus des avantages donnés ci-dessus, le procédé selon l'invention présente des simplifications notables par rapport au procédé connu en réduisant notamment le nombre de masques lithographiques (par exemple photolithographique) en résine nécessaires à la réalisation des transistors. Ainsi, trois niveaux de masquage lithographique au lieu de six, suffisent notamment pour réaliser les points mémoires.

Outre, la simplification du procédé, le nombre réduit de masques lithographiques devrait être bénéfique pour le rendement de la fabrication de points mémoires par exemple EPROM, en série.

De façon avantageuse, le premier, second et troisième masques sont formés chacun de bandes rectilignes parallèles, de largeur constante et équidistantes, les bandes du premier et troisième masques étant perpendiculaires à celles du second masque.

Selon un premier mode de mise en oeuvre du procédé selon l'invention, on réalise les isolations latérales du circuit MIS aprés avoir défini la largeur des canaux et donc la longueur des grilles.

Dans ce premier mode, on effectue avantageusement les étapes suivantes :
(1) dépôts successifs sur le substrat d'une couche d'au moins un premier matériau isolant et d'au moins une couche d'un second matériau conducteur,
(2) réalisation du premier masque,
(3) élimination des régions du second et éventuellement premier matériaux, non masquées par le premier masque, formant ainsi des premières bandes en surplomb parallèles à une première direction,
(4) élimination du premier masque,
(5) remplissage des espaces définis entre les premières bandes par un troisième matériau isolant, constituant les isolations latérales,
(6) réalisation du second masque,
(7) élimination des régions des troisième, second et éventuellement premier matériaux, non masquées par le second masque, formant ainsi des secondes bandes en surplomb parallèles à une seconde direction perpendiculaire à la première direction,
(8) réalisation des sources et des drains par un premier dopage du substrat ayant une conductivité de type inverse de celle du substrat,
(9) élimination du second masque,
(10) réalisation d'espaceurs isolants de part et d'autre des secondes bandes, accolés à ces secondes bandes,
(11) réalisation des secondes lignes conductrices dans les espaces définis entre les espaceurs, la hauteur des secondes lignes étant inférieure à celle des secondes bandes et des espaceurs,
(12) recouvrement des secondes lignes conductrices par un quatrième matériau isolant affleurant le sommt des secondes bandes,
(13) dépôt d'une couche de cinquième matériau conducteur sur toute la structure obtenue,
(14) réalisation du troisième masque,
(15) élimination des régions de cinquième matériau non masquées par le troisième masque, formant ainsi les premières lignes conductrices et,
(16) élimination du troisième masque.

Selon un autre mode de mise en oeuvre du procédé selon l'invention, on réalise les isolations latérales avant de définir la largeur des canaux et donc la longueur des grilles. Ce mode de mise en oeuvre est parfaitement bien adapté à la réalisation d'une cellule mémoire dont les points mémoires comportent une grille flottante et une grille de commande isolées l'une de l'autre. Dans ce cas particulier, le second procédé selon l'invention comprend avantageusement les étapes suivantes :
(I) dépôt d'une couche d'un premier matériau isolant sur l'ensemble du substrat pour former les isolations latérales,
(II) réalisation du premier masque,
(III) élimination des régions de premier matériau non masquées par le premier masque, formant ainsi des premières bandes en surplomb parallèles à une première direction,
(IV) élimination du premier masque,
(V) dépôt d'un second matériau isolant entre les premières bandes,
(VI) dépôts successifs uniquement sur le second matériau, d'un troisième matériau conducteur, d'un quatrième matériau isolant, d'un cinquième matériau conducteur, la hauteur de l'empilement de second, troisième, quatrième et cinquième matériaux étant voisine de celle des premières bandes,
(VII) réalisation du second masque,
(VIII) élimination des régions de cinquième, quatrième, troisième et éventuellement second matériaux non masquées par le second masque, formant ainsi des secondes bandes en surplomb parallèles à une sconde direction perpendiculaire à la première direction,
(IX) réalisation des sources et des drains par un premier dopage du substrat ayant une conductivité de type inverse de celle du substrat,
(X) élimination du second masque,
(XI) réalisation d'espaceurs isolants de part et d'autre des secondes bandes, accolés à ces secondes bandes,
(XII) réalisation des secondes lignes conductrices dans les espaces définis entre les espaceurs, la hauteur des secondes lignes étant infériure à celle des scondes bandes et des espaceurs,
(XIII) recouvrement des secondes lignes conductrices par un sixième matériau isolant, affleurant le sommet des secondes bandes,
(XIV) dépôt d'une couche de septième matériau conducteur sur toute la structure obtenue,
(XV) réalisation du troisième masque,
(XVI) élimination des régions de septième matériau non masquées par le troisième masque, formant ainsi les premières lignes conductrices, et
(XVII) élimination du troisième masque.

Ce second mode de mise en oeuvre est légérement plus simple que le premier mode.

En outre, le couplage capacitif entre la grille de commande et la grille flottante est amélioré : la surface de couplage est plus importante.

D'autres caractéristiques et avantages de l'invention ressortiront mieux de la description qui va suivre, donnée titre illustratif et non limitatif.

La description se réfère aux figures annexées, dans lesquelles :
- la figure 1 déjà décrite, représente schématiquement en perspective, une cellule mémoire EPROM conformément à l'art antérieur ;
- la figure 2 représente schématiquement en perspective, une cellule mémoire EPROM selon l'invention ;
- la figure 3 représente une variante de la cellule de la figure 2 ;
- les figures 4 à 15 illustrent schématiquement les différentes étapes du procédé de fabrication d'un point mémoire EPROM : les figures 4 à 8, 14 et 15 sont des coupes selon la direction X de la cellule, la figure 9 est une vue de dessus, les figures 10 à 13 sont des coupes selon la direction Y de la cellule ;
- les figures 16 à 18 illustrent une variante de mise en oeuvre du procédé selon l'invention : la figure 16 est une vue en coupe selon la direction X et les figures 17 et 18 sont des vues en coupe selon la direction Y de la cellule mémoire ;
- les figures 19 à 23 illustrent schématiquement, selon la direction X de la cellule, une autre variante de mise en oeuvre du procédé conforme à l'invention,
- la figure 24 représente en perspective la cellule EPROM conforme à l'invention résultant du procédé illustré aux figures 19 à 23,
- les figures 25 à 33 illustrent schématiquement les différentes étapes de fabrication d'une cellule mémoire EPROM, selon une variante de réalisation : les figures 25 et 26 et les parties A des figures 29 et 30 sont des coupes selon la direction Y de la cellule, les figures 27, 28, 31, 32 et 33 sont des vues en perspective et les parties B des figures 29 et 30 sont des coupes selon la direction X de la cellule, et
- les figures 34 et 35 représentent schématiquement selon la direction deux modes de réalisation de transistors MOS conformes à l'invention.

La description, ci-aprés, se réfère à une cellule mémoire EPROM formée de point mémoires à canal N réalisés sur un substrat en silicium monocristallin de type p, en vue d'une simplification. Mais bien entendu, l'invention à une porté beaucoup plus générale puisqu'elle s'applique a tout type de mémoires grills flottantes réalisées sur un substrat semiconducteur quelconque.

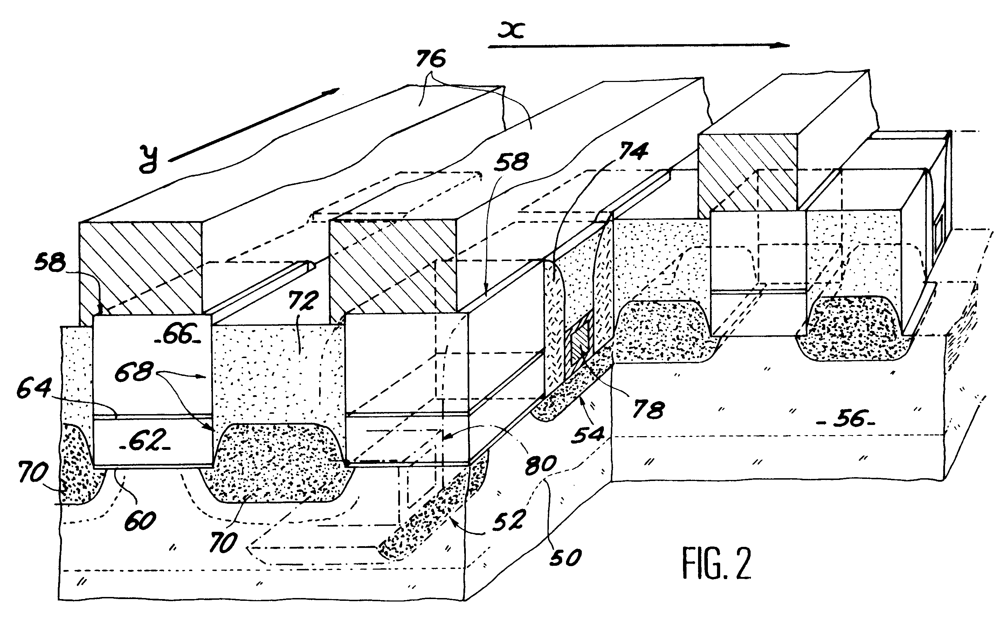

La cellule mémoire EPROM, représentée sur la figure 2 comporte, comme les cellules mémoires de l'art antérieur, une matrice de points mémoires 50 formés de transistors comportant chacun une source 52 et un drain 54 de type n⁺ réalisés dans un substrat 56 en silicium monocristallin de type p. Des empilements 58 de matériaux sont prévus entre les sources et les drains.

Ces empilements 58, en partant du substrat 56, sont formés d'un premier isolant 60 en oxyde de silicium, d'une grille flottante 62 en silicium polycristallin dopé au phosphore, d'un second isolant 64 formé de trois matériaux isolants empilés SiO₂, Si₃N₄ et SiO₂, et d'une grille de commande 66 en silicium polycristallin dopé au phosphore.

Ces empilements sont typiquement compris entre 1000 et 1500 nm contre 600 à 700 nm dans l'état de la technique.

Afin d'isoler électriquement les uns des autres les points mémoires 50, des isolations latérales 68 sont prévues. Ces isolations qui s'accompagnent d'un dopage de type p+ du substrat, peuvent être réalisées en un ou plusieurs matériaux isolants empilés, par exemple une oxydation localisée 70 du substrat surmonté d'un oxyde de silicium (SiO₂) dopé au phosphore 72. En outre des espaceurs 74 en SiO₂ sont prévus, de part et d'autre des empilements 58. Ces espaceurs 74 présentent la form de bandes, orientées selon la direction X perpendiculaire à la longueur des canaux des points mémoires allant de la source au drain des points mémoires.

Conformément à l'invention, la grille flottante 62 et la grille de commande 66 des différents points mémoires ont la même largeur et la même longueur. En outre, ces grilles 62 et 66 ne s'étendent pas au-dessus des isolations latérales 68 et sont auto-alignées (ou auto-positionnées) par rapport à ces isolations.

Selon l'invention, la connexion des grilles de commande 66 entre elles, correspondant aux lignes de mots, est réalisée par des bandes conductrices 76 métalliques, orientées parallèlement à la direction Y des points mémoire. Les bandes 76 peuvent être réalisées en aluminium, en tungsténe, en or, etc.

Par ailleurs, la connexion des drains 54 des points mémoires, correspondant aux lignes d'éléments binaires, est réalisée à l'aide de bandes conductrices 78 parallèles à une direction X qui est perpendiculaire aux lignes métalliques 76 de connexion des grilles et donc à la longueur des canaux des points mémoires.

De même la connexion des sources 52 des points mémoires, correspondant aux lignes d'alimentation des points mémoires est réalisée par des bandes conductrices 80, parallèles aux bandes conductrices 78 de connexion des drains.

Les lignes d'éléments binaires et d'alimentation sont réalisées en une ou plusieurs couches de métal (Al, W, TiW, Mo Ta, etc) ou d'un siliciure d'un métal réfractaire tel que TiSi₂, TaSi₂, MoSi₂, WSi₂.

Pour lire le contenu d'un point mémoire particulier, il faut activer la ligne d'alimentation 80 correspondante, les autres lignes d'alimentation n'étant pas polarisées. Ceci est nécessaire étant donné que deux points mémoires voisins, qui partagent la même ligne d'éléments binaires 78 sont activés par la même ligne de mots 76. Il est aussi possible de polariser toutes les lignes de mots et de mettre à la masse celle du point mémoire que l'on sélectionne (lecture).

Afin d'éviter une éventuelle complication des circuits de commande de la mémoire ainsi qu'un perte en temps d'accès de celle-ci, il est possible de séparer les lignes d'éléments binaires 78 de deux points mémoires voisins.

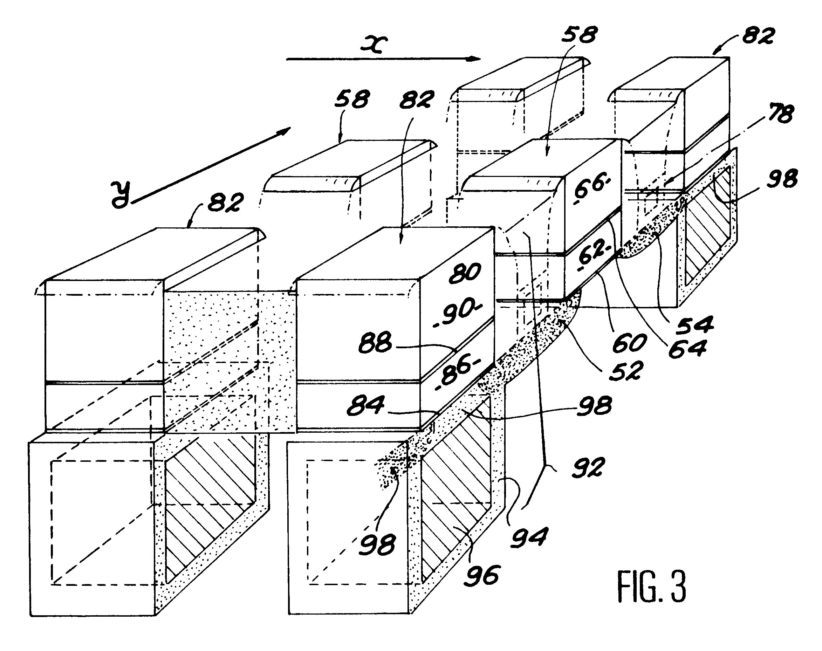

A cet effet, la cellule mémoire de l'invention comprend de plus, comme représenté sur la figure 3, des seconds empilements 82 de matériaux répartis en matrice comme les points mémoires.

Ces seconds empilements, sont intercalés entre deux points mémoires voisins de la cellule, selon la direction Y. Ils sont identiques en tout point aux empilements 58 et formés en particulier, en partant du substrat 56, d'un isolant 84 en oxyde de silicium, d'un matériau conducteur 86 en silicium polycristallin dopé au phosphore, d'un isolant 88 de type tricouche, SiO₂-Si₃N₄-SiO₂, et d'un matériau conducteur 90 en silicium polycristallin dopé au phosphore.

Ces seconds empilements sont réalisés en même temps que les premiers empilements en utilisant les mêmes masques photolithographiques, les mêmes couches de matériaux et les mêmes étapes de gravure.

Selon l'invention, une tranchée d'isolement de référence générale 92 est prévue sous chaque second empilement 82. Ces tranchées d'isolement sont réalisées dans le substrat avant toute étape de sa fabrication des points mémoires, des isolations latérales, et des connexions de ces points mémoires.

Ces tranchées d'isolement 92 sont obtenues de façon connue en effectuant tout d'abord une gravure anisotrope du type ionique réactive du substrat 56 sur une épaisseur d'environ 5000nm, à l'aide d'un masque de gravure en résin photosensible approprié. On réalise ensuite une oxydation thermique des flancs des tranchées afin de former un film 94, sur les côtés et le fond de chaque tranché, en oxyde de silicium. On effectue alors un remplissage de la tranchée par du silicium polycristallin 96. Ce remplissage se fait par la technique de dépôt chimique en phase vapeur (CVD).

Après élimination du silicium polycristallin situé en dehors de la tranchée, notamment par une gravure ionique réactive, on effectue une oxydation thermique en surface de ce silicium afin de former une couche de SiO₂ 98 à la surface de la tranchée.

Ces tranchées d'isolement peuvent aussi être utilisées pour l'isolation des circuits périphériques CMOS des points mémoires.

En dehors de ces tranchées d'isolement, le procédé de fabrication de cette cellule mémoire est inchangé par rapport au procédé relatif à une cellule mémoire sans tranchées. Toutefois, la surface de la cellule mémoire est augmentée de 50%, mais cette augmentation permet d'obtenir une cellule mémoire de dimension inférieure à celle obtenue par les procédés conventionnels.

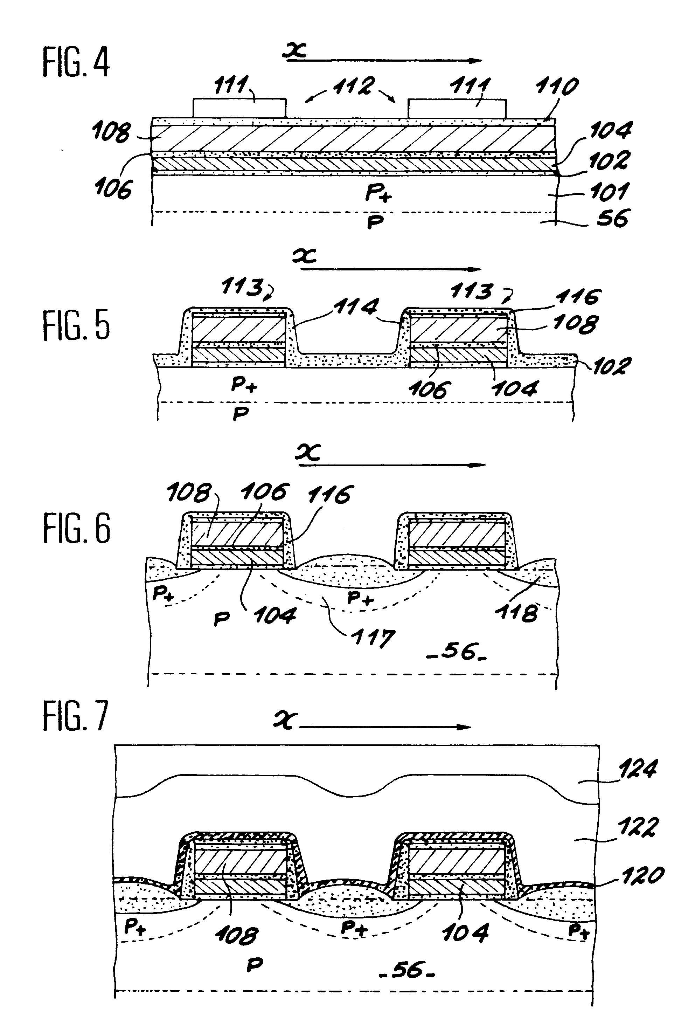

On va maintenant décrire, en référence aux figures 4 à 15, un premier procédé de fabrication d'une cellule mémoire selon l'invention telle que représentée sur la figure 2.

Ce premier procédé consiste tout d'abord, comme représenté sur la figure 4, recouvrir un substrat semiconducteur 56 en silicium monocristallin par exemple de type p, d'une couche 102 d'oxyde de silicium (SiO₂). Cette couche 102 présente une épaisseur d'environ 25 nm et est obtenue par oxydation thermique du substrat, à une température voisine de 900°C. Cette couche 102 constituera ultérieurement l'oxyde de grille des points mémoires à réaliser.

A travers cette couche 102 d'oxyde de silicium, on réalise ensuite un dopage 101 du substrat 56 servant à ajuster la tension de seuil des points mémoires. Ce dopage ayant une conductivité de même type que celle du substrat peut être obtenu en implantant des ions de bore pour un substrat de type p à une dose de 10¹² ions/cm² avec une énergie de 50 keV.

On dépose ensuite une couche 104 de silicium polycristallin dopé au phosphore par diffusion de POCL₃. Cette couche 104 déposée par un procédé de dépôt chimique en phase vapeur (CVD ou LPCVD) présente une épaisseur de 250 nm. Dans cette couche 104, sera réalisée ultérieurement la première grille ou grille flottante des points mémoires.

Sur la couche 104, on réalise ensuite l'isolant 106 inter-grille. Cet isolant 106 peut être obtenu par oxydation thermique du silicium polycristallin de la couche 104 à 900°C, sur une épaisseur de 25 nm, puis en déposant une couche de nitrure de silicium de 15 nm par CVD et en oxydant en surface cette couche de nitrure, sur une épaisseur de 5 nm, par oxydation thermique à 900°C.

Il est possible de remplacer cet isolant complexe par une simple couche d'oxyde de silicium obtenu par oxydation thermique à 900°C de la couche 104 en silicium polycristallin.

Sur l'isolant 106, on dépose ensuite une autre couche de silicium polycristallin 108, dopé au phosphore par diffusion de POCL₃, dans laquelle sera réalisée ultérieurement la seconde grille ou grille de commande des points mémoires. Cette couche 108 peut être obtenue par la technique de dépôt chimique en phase vapeur (CVD ou LPCVD) et présenter une épaisseur de 1000nm.

On dépose ensuite sur la couche 108 une couche 110 de nitrure de silicium par exemple par la technique de dépôt chimique en phase vapeur à basse pression (LPCVD). Cette couche 110 présente une épaisseur d'environ 100 nm. Elle assure une protection de la couche 108 de silicium polycristallin lors des étapes ultérieures.

On réalise ensuite selon les procédés classiques de photolithographie un masque de résine 112 permettant de définir la largeur des canaux et donc la longueur des grilles flottantes et des grilles de commande des points mémoires, ainsi que celle des isolations latérales.

Pour réaliser plusieurs points mémoires répartis en matrice à la surface du substrat 100, ce masque 112 présente la forme de bandes rectilignes 111 parallèles entre elles et la direction Y, correspondant à la direction des lignes des éléments binaires. Ces bandes 111 présentent une largeur constante et sont équidistantes ; elles sont espacées par exemple de 1000nm et ont une largeur de 1000nm.

Comme représenté sur la figure 5, on élimine ensuite les régions des différentes couches 110, 108, 106 et 104 empilées non recouvertes de résine 112, formant ainsi des bandes 113 de matériaux parallèles à la direction Y.

Cette élimination peut être réalisée par des gravures anisotropes du type ionique réactive, successives, en utilisant comme agent d'attaque du trifluorométhane (CHF₃) pour les couches en oxyde de nitrure de silicium et de l'hexafluorure de soufre (SF₆) pour les couches en silicium polycristallin.

L'utilisation d'agents d'attaque différents, suivant la nature des couches, permet d'utiliser la couche située en-dessous de celle que l'on grave comme couche d'arrêt de gravure ceci permet de compenser les inhomogénéités d'épaisseur de ces différentes couches.

Il est éventuellement possible de graver aussi la couche 102 d'oxyde de silicium, à l'aide d'un plasma de CHF₃, et une faible épaisseur du substrat 56 en vue de réaliser ultérieurement un oxyde de champ partiellement enterré. La gravure du substrat 100 put être réalisé sur une épaisseur de 400 nm par une gravure ionique réactive en utilisant comme agent d'attaque du SF₆.

Après élimination du masque de résine 112 par un plasma d'oxygène, on effectue éventuellement, comme représenté sur la figure 6, une oxydation des flancs gravés des bandes 113 des différentes couches 110-102, d'environ 30 nm à une température de 900°C sous atmosphère d'oxygène. Les flancs oxydés portent la référence 114.

On dépose ensuite sur l'ensemble de la structure une couche de nitrure de silicium 116 d'environ 20 nm par la technique de dépôt chimique en phase vapeur à basse pression. Puis on effectue une gravure pleine plaque (c'est-à-dire sans masque) de la couche 116 de Si₃N₄, avec un plasma de CHF₃, sur une épaisseur d'environ 20 nm. Ceci permet de ne laisser du nitrure de silicium que sur les flancs de l'empilement 113 gravé et sur le dessus de cet empilement, comme représenté sur la figur 6.

On réalise ensuite un dopage du substrat ayant une conductivité de même type que celle du substrat. Ce dopage peut être effectué par implantation d'ions de bore dans le cas d'un substrat de type p, à une énergie de 80 keV et à une dose de 10¹² ions/cm². Ce dopage permet d'obtenir, entre les empilements des couches gravées, des régions 117 de type p+.

Ensuite on oxyde thermiquement le substrat, sur une épaisseur d'environ 500 nm, constituant ainsi un oxyde de champ localisé 118 servant à isoler latéralement les points mémoires entre eux. Cette oxydation thermique n'est pas indispensable. Toutefois sa présence permet de réduire les capacités des lignes d'éléments binaires ou connexions des drains entre eux.

Sur la structure obtenue, on dépose ensuite, comme représenté sur la figure 7, une couche 120 de nitrure de silicium, d'une épaisseur d'environ 50 nm. Cette couche 120 peut être déposée par la technique de dépôt chimique en phase vapeur à basse pression. Puis on recouvre l'ensemble de la structure d'une couche 122 d'oxyde de silicium (SiO₂) dopé au phosphore, par exemple 6% en poids de phosphore, par la technique de dépôt chimique en phase vapeur à basse pression. Cette couche 122 présente une épaisseur de 1200 nm environ.

Ensuite, on effectue un traitement thermique de la couche 122, par exemple à une température de 1050°C pendant 15 min., de façon à faire fluer et densifier ladite couche. En l'absence de l'oxyde de champ 118, cette couche isolante 122 sert d'isolation latéral entre les points mémoires.

On dépose alors, de façon connue, une couche de résine 124 photosensible, effaçant le relief de la couche 122. Cette couche de résine 124, dite de planarisation présente une épaisseur d'environ 1500 nm. Le dépôt de celle-ci peut être suivi d'un traitement thermique, par exemple d'un chauffage à une température de l'ordre de 200°C pendant une demi-heure, de façon à obtenir un bon étalement de cette couche de résine.

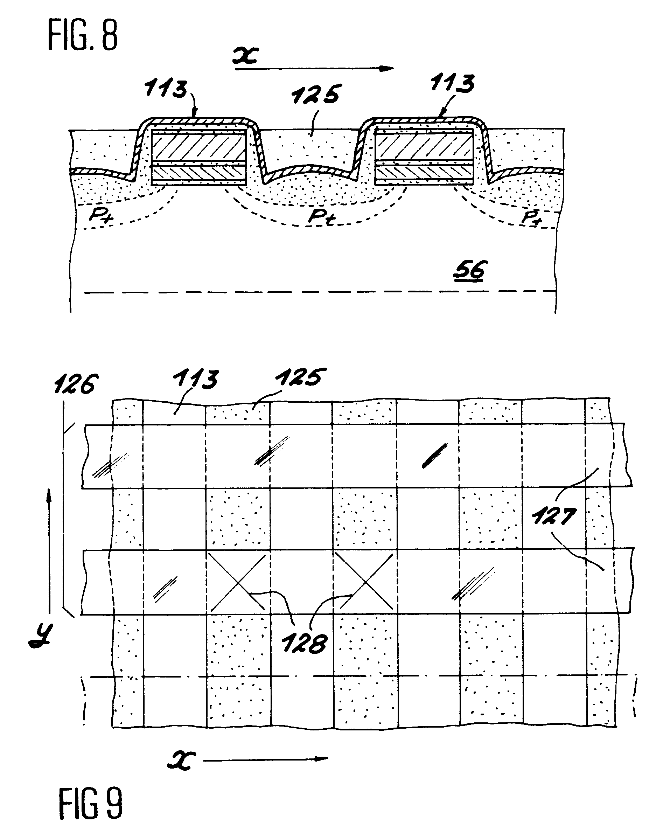

On effectue ensuite une gravure simultanée de la couche de résine 124 et de la couche d'oxyde 122, à des vitesses d'attaque identiques pour la résine et l'oxyde jusqu'à mise à nu de la surface des bandes 113 des couches gravées 104, 106, 108, 110 et 116, comme représenté sur la figure 8. Ainsi la hauteur des bandes 125 isolantes formées est voisine de celle des bandes 113.

Cette gravure est réalisée par exemple de façon anisotrope par un procédé de gravure ionique réactive utilisant comme agent d'attaque un mélange de tri ou tétrafluorométhane et d'oxygène : les composés fluorés servent à la gravure de l'oxyde de silicium et l'oxygène à la gravure de la résine.

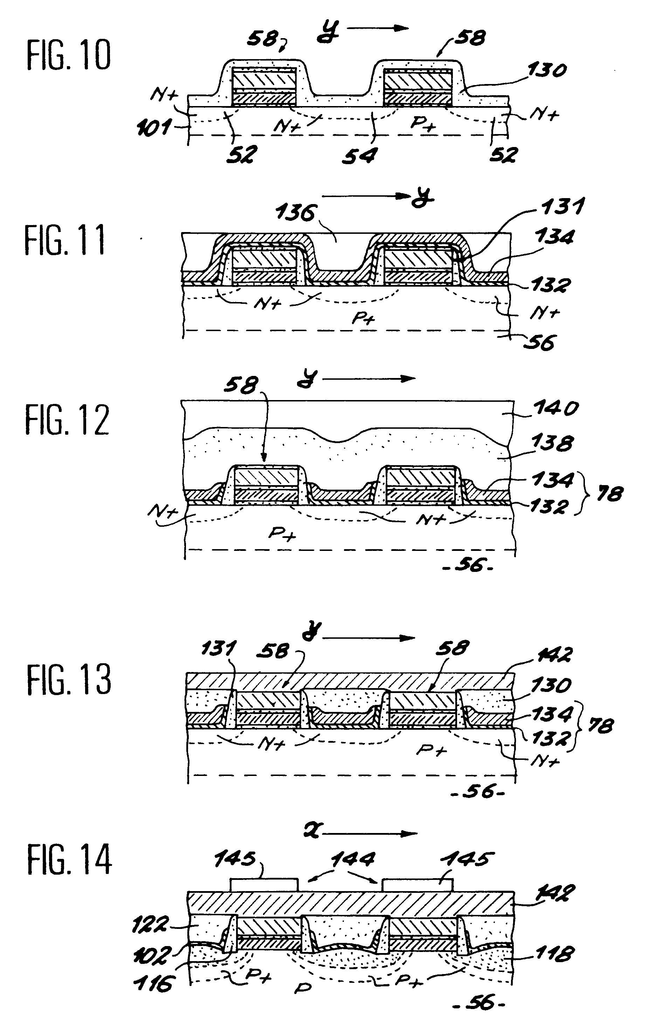

On réalise alors, comme représenté sur la figure 9, un masque de résine 126 permettant de définir la largeur des grilles des points élémentaires et donc la longueur des canaux. Ce masque 126 se présente sous la forme de bandes 127 rectilignes parallèles à la direction X.

La largeur de ces bandes 127 est éventuellement égale à celle des bandes 111 du masque 112 afin d'obtenir des grilles flottantes et de commande ayant une largeur et une longueur identiques. Ces bandes 127 du masque 126 ont une largeur de 1000 nm et sont espacées d'environ 1500 nm.

Comme représenté sur la figure 10, on élimine ensuite les régions des bandes 113 des couches 110, 108, 106, 104 et éventuellement 102 non masquées par le masque 126.

Cette élimination peut être réalisée par des gravures anisotropes successives du type ioniques réactives, en utilisant des agents d'attaque différents suivant la nature des couches. Les couches d'oxyde de silicium et de nitrure de silicium peuvent être gravées avec du trifluorométhane, les couches en silicium polycristallin avec de l'hexafluorure de soufre. Les empilements 58 (figure 2) des grilles flottantes et de commande sont alors achevés.

On effectue alors une seconde gravure de la couche d'oxyde 122 afin de ne garder de l'oxyde que dans les régions 128 situées entre deux empilements successifs selon la direction X, comme représenté sur la figure 9. Cette gravure est effectuée de façon anisotrope à l'aide d'une gravure de type ionique réactive utilisant comme agent d'attaque du CHF₃ ou du CF₄. Les isolations latérales de surface sont alors terminées.

Ensuite, on élimine le masque de résine 126 par un plasma d'oxygène.

On réalise ensuite, comme représenté sur la figure 10, les sources 52 et les drains 54 des points mémoires en effectuant un dopage du substrat 56 ayant une conductivité inverse de ce dernier. Dans le cas d'un substrat de silicium de type p, ce dopage peut être réalisé en implantant des ions d'arsenic une dose de 5.10¹⁵ ions/cm² avec une énergie de 100 keV.

On effectue alors un traitement thermique, par exemple à 850°C pendant 30 min., afin d'activer électriquement les ions implantés dans le substrat 56.

On dépose ensuite une couche 130 d'oxyde de silicium (SiO₂). Cette couche isolante présente par exemple une épaisseur de 300 nm et peut être déposée de façon isotrope par un procédé de dépôt chimique en phase vapeur à basse pression.

On effectue alors, comme représenté sur la figure 11, une gravure de cette couche 130 afin de ne garder que des bandes isolantes, telles que 131, sur tous les flancs gravés de la structure. Ces bandes isolantes 131 ou espaceurs sont notamment présentes tout autour des empilements de grilles 58 des points mémoires et de part et d'autre des isolations latérales de surface 128 (couche 122 gravée).

Ces bandes ou espaceurs 131 sont obtenues par une gravure anisotrope notamment du type ionique réactive afin d'obtenir des espaceurs dont la largeur est définie par l'épaisseur de la couche 130 déposée de façon isotrope. En particulier, une couche 130 de 300 nm d'épaisseur permet d'obtenir des espaceurs 131 de 300 nm de large.

La gravure de la couche isolante 130 est effectuée sans masque de résine (gravure pleine plaque) avec du trifluorométhane par exemple.

L'étape suivante du premier procédé consiste à déposer une ou deux couches conductrices sur l'ensemble de la structure, dans lesquelles seront réalisées les différentes connexions des sources et des drains de la cellule mémoire. Ces couches peuvent être réalisées en n'importe quel matériau généralement utilisé dans la fabrication des circuits intégrés, (aluminium, tungstène, siliciure, etc). L'empilement des couches conductrices présente une épaisseur infériure à celle des empilements 58 et des espaceurs 131 mais au moins égale à 300 nm.

A noter que la dimension la plus petite des sources et drains ne doit pas dépasser environ 2 fois l'épaisseur de cet empilement conducteur afin d'éviter, lors de la gravure ultérieure de cet empilement, d'attaquer la zone de cet empilement directement au contact des sources et des drains. La dimension la plus faible ds sources et drains doit donc aller de 1 à 2 micromètres dans l'exemple particulier.

En particulier, ces différentes connexions peuvent être définies dans une couche unique de tungstène déposée par la technique de dépôt chimique en phase vapeur (CVD) et ayant une épaisseur de 600 nm. Un tel matériau permet de diminuer d'un facteur 10 au moins la résistance carrée des sources et drains des points mémoires. Elles peuvent aussi être définies, comme représenté sur la figure 11, dans un empilement de deux couches 132 et 134 réalisées respectivement en un alliage de titane et de tungstène (TiW) et en aluminium.

La couche 132 de TiW de 100 nm d'épaisseur peut être déposée par pulvérisation magnétron cette couche sert de barrière de diffusion d l'aluminium dans les couches sous-jacentes notamment en silicium.

La couche 134 en aluminium peut être déposée par un procédé de pulvérisation magnétron et présenter une épaisseur de 400 nm.

On dépose ensuite sur la ou les couche(s) conductrice(s) une couche de résine photosensible 136 par exemple de 1800 nm. Eventuellement, on effectue un traitement thermique de cette couche de résine, par exemple une cuisson de l'ordre de 200°C pendant 15 min., afin d'obtenir un bon étalement de celle-ci.

On réalise alors une gravure de cette couche de résine 136 afin de ne garder de la résine que dans les parties en creux du relief de la structure. La structure résultante présente alors une surface plane, comme représenté sur la figure 11.

Dans le cas d'un empilement de couches de TiW 132 et d'aluminium 134, on élimine ensuite les régions de la couche 134 puis de la couche 132 non recouvertes de résine 136. Cette élimination peut être effectuée à l'aide d'une gravure anisotrope du type gravure ionique réactive en utilisant comme agent d'attaque du tétrafluorure de carbone pour la couche 134 en aluminium et de l'hexafluorure de soufre pour la couche 132 en TiW. La gravure des couches 134 et 132 est réalisée sur une épaisseur de 500 nm environ en-dessous de l'empilement 58 gravé des couches 110, 108, 106, 104 et éventuellement 102 pour éviter ultérieurement un court-circuit entre les lignes conductrices 76 et 78 d'une part et 76 et 80 d'autre part.

Dans le cas d'une seule couche conductrice en tungstène, on effectue une gravure de cette couche conductrice ainsi que de la résine la recouvrant, sur une épaisseur d'environ 500 nm en-dessous de l'empilement 58.

Les connexions 78, 80 entre les sources d'une part et les drains d'autre part des points mémoires sont alors achevées (figure 2).

Après gravure de la ou les couche(s) conductrice(s), on élimine la résine 136 restante en utilisant par exemple un plasma d'oxygène. La structure résultante est celle représentée sur la figure 12.

L'utilisation d'une couche de résine 136 telle que définie ci-dessus, permet la réalisation de contacts électriques et de connexions 70 et 80 (figure 2) entre les sources et drains des différents points mémoires, auto-positionnés ou alignés par rapport à la grille flottante 62 et à la grille de commande 66 de ces points.

En outre, elle permet d'augmenter de façon considérable la densité d'intégration des mémoires EPROM, par rapport à l'art antérieur, par suppression de la couche d'oxyde de silicium 22 dans laquelle sont réalisés les trous de contact électrique 24 des sources et des drains des points mémoires de l'art antérieur, et donc des gardes isolantes 30.

On effectue ensuite le dépôt d'une couche 138 d'oxyde de silicium, dopée ou non au phosphore, ayant une épaisseur d'environ 700 nm. Cette couche 138 put être déposée par la technique de dépôt chimique en phase vapeur à basse pression.

Cette couche 138 est ensuite recouverte d'une couche 140 de résine photosensible d'environ 1800 nm. Le traitement thermique, par exemple un chauffage à une température de 200°C pendant 1 demi-heure, permet d'obtenir un bon étalement de cette couche de résine 140.

On effectue ensuite une gravure simultanée de la couche d'oxyde 138 et de la résine 140, à des vitesses d'attaque identiques pour la résine et l'oxyde jusqu'à ce que le sommet des empilements 58 soit mis à nu. La structure obtenue est celle représentée sur la figure 13.

Cette gravure est réalisée de façon anisotrope par une gravure du type ionique réactive en utilisant des agents fluorés (CHF₃ ou CF₄) et de l'oxygène ; les composés fluorés servant à graver l'oxyde et l'oxygène à graver la résine.

On élimine ensuite le restant de la couche de nitrure 110 mise à nu par une gravure ionique réactive utilisant du CHF₃ comme agent de gravure. Puis on dépose sur l'ensemble de la structure une couche métallique 142 par exemple en aluminium sur une épaisseur de 800 nm. Cette couche d'aluminium peut être déposée par pulvérisation magnét

On réalise, ensuite, comme représenté sur la figure 14, un nouveau masque de résine photosensible 144 définissant les lignes de connexion des grilles selon la direction Y, correspondant aux lignes de mots. Ce masque 144 se présente sous la forme de bandes 145 parallèles à la direction Y. Il est identique au masque 112.

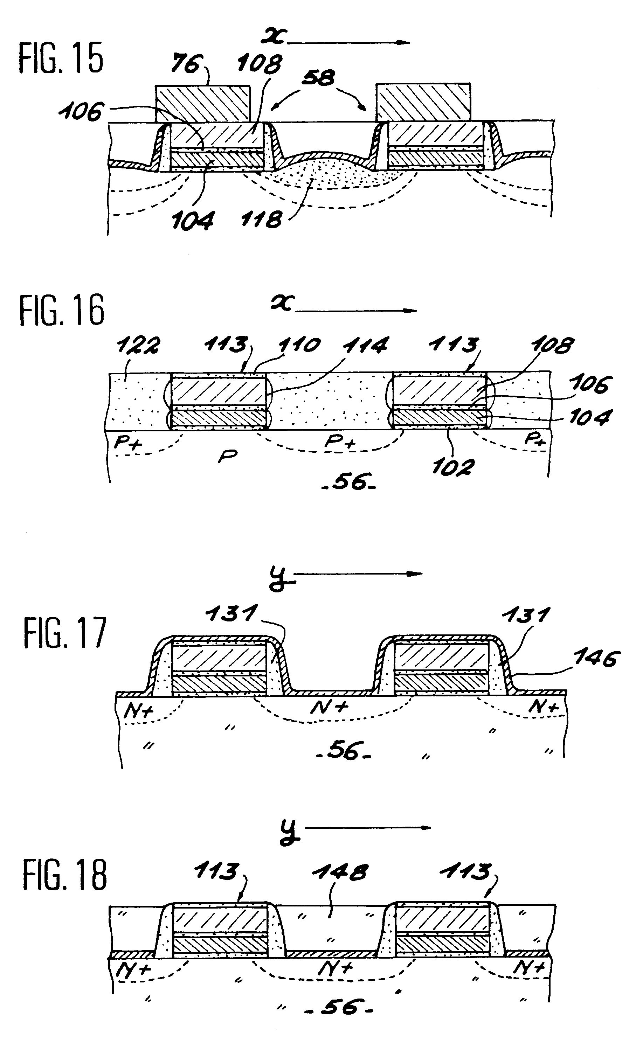

On effectue ensuite une élimination des régions de la couche 142 non masquées. Cette gravure peut être réalisée par une gravure anisotrope du type ionique réactive en utilisant du tétrachluorure de carbone comme agent d'attaque. La structure résultante est celle représentée sur la figure 15. Les lignes de mots ou connexions des grilles 76 de la cellule mémoire sont alors achevées. On élimine ensuite le masque de résine 144 par plasma d'O₂.

La dernière étape du procédé consiste à déposer une couche de passivation, généralement en oxyde de silicium sur l'ensemble de la structure.

Le procédé selon l'invention décrit précédemment permet d'obtenir une structure quasi-plane. En outre, ce procédé ne faisant intervenir que trois niveaux de masquage 112, 126, 144 est beaucoup plus simple que ceux de l'art antérieur. De plus, aucune des étapes décrites ci-dessus n'est critique.

Sur les figures 16 à 18, on a représenté schématiquement une variante du procédé décrit ci-dessus, variante due à l'utilisation de lignes conductrices 78 des éléments binairs, selon la direction X, en siliciure (siliciure de tungstène, de titane, de tantale, de platine, de molybdène, etc).

Dans cette variante, on effectue directement après l'oxydation 114 des flancs gravés des bandes 113 (empilements des couches 102, 110) un dopage du substrat, de même type de conductivité que celui du substrat 56, au-dessus duquel seront réalisées les isolations latérales des différents points mémoires. Ce dopage est réalisé en implantant des ions de bore, dans le cas d'un substrat de type p, à une énergie de 80 keV et à une dose de 10¹² ions/cm². Il permet d'obtenir entre les bandes 113 les régions 117 de type p+.

Après ce dopage, on dépose directement la couche 122 de SiO₂ dopé au phosphore comme représenté sur la figure 16.

Cette variante de procédé se distingue donc de celle décrite en référence aux figures 4 à 15 par l'absence du dépôt de la couche de nitrure 116, de sa gravure, de l'oxydation thermique pour former l'oxyde de champ 118, et du dépôt de la couche de nitrure de silicium 120.

Après gravure, comme précédemment, de la couche 122 simultanément la couche de résine 24 de la définition de la longueur du canal des points mémoires, de la réalisation des sources 52 et drains 54 de ces points et de la formation des espaceurs 131 en oxyde de silicium, on dépose, comme représenté sur la figure 17, une couche 146 en un métal apte à former un siliciure. Cette couche est par exemple une couche de titane d'environ 30 nm déposée par pulvérisation magnétron.

L'ensemble de la structure est ensuite soumis à un recuit, à une température de 600°C pendant 15 min. environ, en atmosphère de gaz neutre, tel que de l'azote. Ce recuit permet de former un siliciure par réaction du métal (titane) avec le silicium du substrat 56. Cette réaction chimique n'est bien entendu possible que si la couche d'oxyde 102 a été précédemment gravée à l'aide du masque 112 (figure 4).

On élimine ensuite les parties de la couche 146 non en contact avec le silicium et par conséquent n'ayant pas formé de siliciure. L'élimination sélective du titane par rapport au siliciure de titane est effectuée par voie chimique en phase humide en utilisant un mélange d'acid nitrique et d'acide fluorhydrique (HNO₃ et HF).

On dépose ensuite une couche isolante 148 en verre borophosphosilicaté d'environ 1000 nm qui joue le même rôle que la couche 138 en oxyde de silicium (figure 12). Ce dépôt de la couche 148 est effectué par la technique de dépôt chimique en phase vapeur.

On effectue alors un traitement thermique de cette couche 148 en vue de la faire fluer et de la densifier, par exemple à une température de 850°C pendant 30 min.

Cette couche 148 est ensuite recouverte, comme précédemment, de la couche de résine 140, puis gravée simultanément avec cette couche de résine afin de ne garder de l'isolant 148 qu'entre les empilements ds couches gravées, comme représenté sur la figure 18.

La réalisation des lignes conductrices 78 des éléments binaires en siliciure permet d'éviter le dépôt de la couche de résine 136, la gravure simultanée de cette couche avec la couche conductrice sous-jacente, ainsi que l'élimination de la résine 136 restante. Cette variante offre donc un certain nombre de simplifications les autres étapes du procédé restent inchangées.

Dans cette variante, il est possible de réduire l'épaisseur de l'empilement des couches gravées 102-110 notamment en utilisant une couche de silicium polycristallin 108 ayant une épaisseur de 600 nm au lieu de 1000 nm.

Dans le procédé décrit précédemment en référence aux figures 4 à 15 ainsi que dans sa variant décrite en référence aux figures 16 à 18, les isolations latérales servant isoler entre eux les points mémoires sont réalisées après avoir défini (masquage et gravure) la longueur des grilles flottantes et des grilles de commande de ces points.

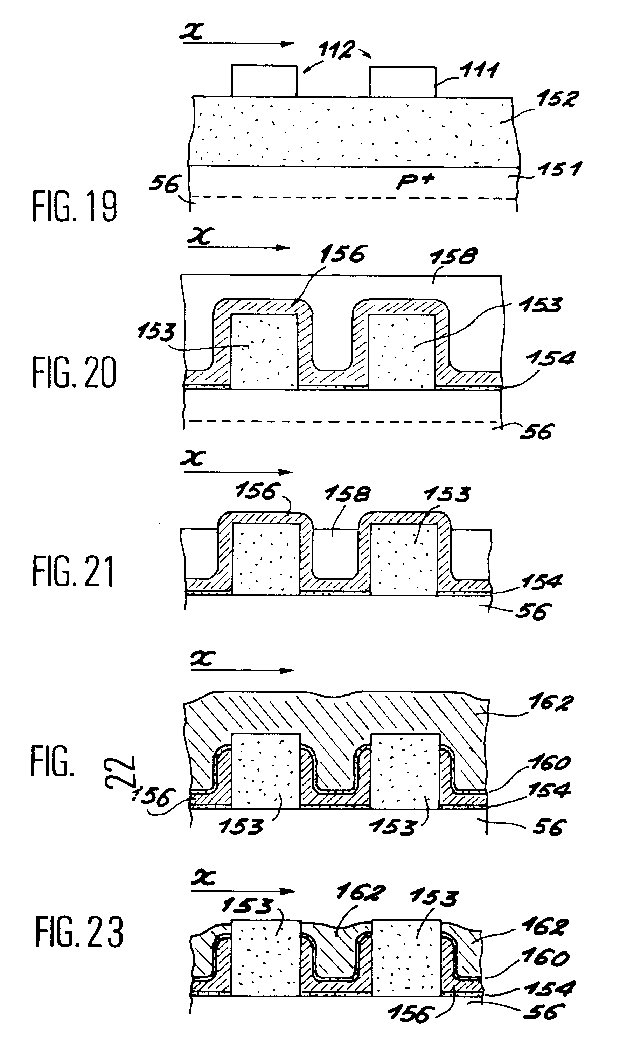

On va maintenant décrire en référence aux figures 19 à 23, un autre procédé de fabrication d'une mémoire EPROM selon l'invention dans lequel les isolations latérales sont réalisées avant de définir la longueur des grilles flottantes et de commande. Cette description se réfère encore à une cellule mémoire ne comportant pas de tranchée d'isolement (figure 3). Les couches de matériau et les masques inchangés par rapport à ceux du procédé précédent portent les mêmes références.

Dans un substrat 56 en silicium monocristallin de type p, on effectue tout d'abord un dopage de ce substrat ayant une conductivité de même type que celle du substrat, qui constituera le dopage des isolations latérales de la cellule mémoire. Ce dopage peut être obtenu par implantation d'ions de bore, à une énergie de 80 keV et à une dose de 10¹² ions/cm². Il permet d'obtenir une couche superficielle de type p+ portant la référence 151, comme représenté sur la figure 19.

On dépose ensuite une couche 152 d'oxyde de silicium (SiO₂) non dopée par la technique de dépôt chimique en phase vapeur à basse pression. Cette couche 152 présente une épaisseur de 2000 nm environ. C'est dans cette couche isolante que seront définies ultériurement les isolations latérales de surface entre les points mémoires.

On réalise ensuite, selon les procédés classiques de photolithographie, le masque de résine 112 permettant de définir la longueur des grilles flottantes et des grilles de commannde des points mémoires ainsi que celles des isolations latérales. Ce masque 112 se présent sous la forme de bandes 111 rectilignes parallèles entre elles à la direction Y de la cellule mémoire. Ces bandes de largeur constante sont espacées de 1000 nm et ont une largeur de 1000 nm.

On effectue ensuite, comme représenté sur la figure 20, une gravure de la couche isolante 152, consistant à éliminer les régions de cette couche non masquées par la résine. Ceci est réalisé par une gravure anisotrope de type ionique réactive en utilisant un plasma d CHF₃. La gravure est réalisée sur toute l'épaisseur de la couche 152. On obtient ainsi des bandes 153 isolantes parallèles entre elles qui joueront le rôle d'oxyde de champ.

Le masque 112 est ensuite éliminé par ddissolution dans une cétone.

Entre les bandes 153, on réalise alors l'oxyde de grille 154, comme représenté sur la figure 20. Cet oxyde est formé par oxydation thermique à 900°C des régions du substrat mises à nu. Cet oxyde de grille 154 présente une épaisseur de 20 nm.

Aprés formation de l'oxyde de grille, on effectue un dopage du substrat servant à ajuster la tension de seuil des points mémoires. Ce dopage ayant une conductivité de même type que celle du substrat est obtenu en implantant des ions de bore à une dose de 3.10¹¹ ions/cm² et une énergie de 50 keV.

Sur la structure obtenue, on dépose alors une couche 156 de silicium polycristallin dopé au phosphore par diffusion de POCL₃. Cette couche 156 déposée par un procédé de dépôt chimique en phase vapeur (CVD) présente une épaisseur de 250 nm. C'est dans cette couche que sera réalisée ultérieurement la grille flottante des points mémoires.

On dépose alors, de façon connue, une couche de résine photosensible 158 effaçant le relief de la couche 156. Cette couche de résine présente une épaisseur d'environ 1500 nm. Son dépôt peut être suivi d'un traitement thermique, par exemple d'un chauffage à une température de l'ordre de 200°C pendant une demi-heure, de façon à obtenir un bon étalement de la résine.

On réalise alors une gravure de cette couche de résine 158 afin de ne garder de la résine que dans les parties en creux du relief de la structure ; le sommet de la résine restante est située à environ 700 nm en-dessous du sommet de la couche 156 de silicium polycristallin. La structure résultante est représentée sur la figure 21.

On élimine ensuite les régions de la couche 156 en silicium polycristallin non recouvertes de résine. Cette gravure est réalisée de façon anisotrope avec une gravure de type ionique réactive en utilisant un plasma d'hexafluorure de soufre. Cette gravure est réalisée sur une épaisseur de 700 nm, ce qui fait que les sommets des flancs de la couche 156 gravée, remontant sur les flancs des bandes 153 sont situés en-dessous des sommets des bandes 153. On élimine ensuite la résine restante en utilisant par exemple un plasma d'oxygène. La structure résultante est celle représentée sur la figure 22.

On réalise ensuite l'isolant inter-grille 160. Cet isolant peut être obtenu par oxydation thermique du silicium polycristallin de la couche 156, à 900°C, sur une épaisseur de 25 nm, puis en déposant une couche de nitrure de silicium de 15 nm par CVD sur l'ensemble de la structure puis en oxydant thermiquement à 900°C la surface de cette couche de nitrure sur une épaisseur de 5 nm.

Sur l'ensemble de la structure, on dépose alors une autre couche de silicium polycristallin 162 dopé au phosphore par diffusion de POCL₃, remplissant tout l'espace compris entre deux bandes 153 isolants. Ceci peut être obtenu avec un dépôt isotrope dont l'épaisseur est au moins égale à la moitié de l'espace inter-bande (pour des bandes isolantes distantes de 1000 nm, un dépôt CVD de 500 nm est suffisant). Dans le cas présent, la couche 162 présente une épaisseur de 800 nm et peut être déposée par LPCVD.

On effectue alors, comme représenté sur la figure 23, une gravure pleine plaque de la couche de silicium 162 (c'est-à-dire sans masque) afin de dégager le sommet des bandes isolantes 153. Cett gravure est réalisée de façon anisotrope avec un plasma de SF₆.

Ce procédé se poursuit par réalisation du second masque servant à définir la largeur des canaux des points mémoires (figure 9). Les étapes ultérieures sont identiques à celles décrites en référence aux figures 9 à 18. En particulier, les connexions inter-drains peuvent être réalisées en métal (figure 11) ou en siliciure (figure 17).

Dans ce procédé, le dopage 151 pleine plaque du substrat comme première étape réalise, en plus du dopage des isolations latérales, un dopage du canal des points mémoires. Toutefois, ceci n'est pas gênant pour des canaux ayant une longueur inférieure ou égale à 1000 nm car, pour de telles longueurs, le dopage des canaux doit être élevé.

En outre, la couche d'oxyde 152 dans laquelle sont réalisées les isolations latérales doit être non dopée afin d'éviter un auto-dopage de l'isolant de grille 154 obtenu par oxydation thermique du substrat.

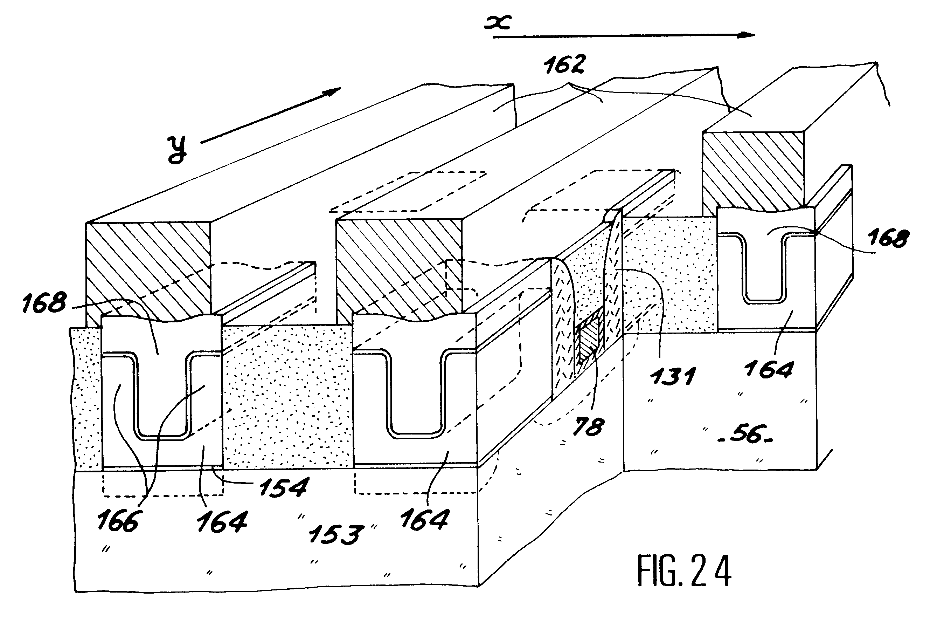

Ce procédé permet d'obtenir une cellule mémoire EPROM telle que représentée en perspective sur la figure 24.

Chaque point mémoire de cette cellule comprend une grille flottante 164 en forme de U dont le fond est au contact de l'isolant de grille 154 et contrôle la longueur du canal du point mémoire. Les flancs 166 remontant de cette grille augmente la surface de couplage entre la grille flottante 164 et la grille de commande 168, ce qui permet d'améliorer le couplage capacitif entre la grille de commande 168 et la grille flottante 164.

Cette amélioration de couplage permet, par rapport à la cellule mémoire représentée sur la figure 2, d'améliorer l'efficacité de la cellule mémoire lors de la lecture mais surtout de l'écriture dans ladite cellule.

Cette cellule mémoire peut bien entendu être équipée de tranchées d'isolement telles que décrites en référence à la figure 3.

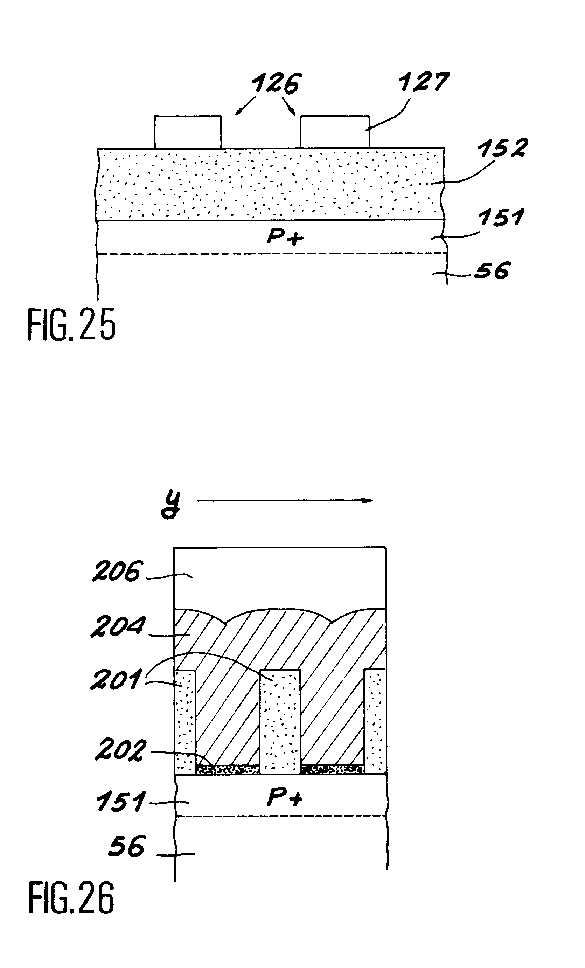

On va décrire ci-après en référence aux figures 25 à 33 une variante du procédé de fabrication décrit ci-dessus permettant d'obtenir une cellule mémoire EPROM comportant une grille flottante en form de "cuvette", c'est-à-dire présentant selon deux directions perpendiculaires X et Y la forme d'un U. Les couches de matériaux et les masques inchangés par rapport à ceux décrits en référence aux figures 19 à 23 portent les mêmes références.

Après avoir réalisé le dopage 151 de type p+, dans le substrat en silicium monocristallin 56, des isolations latérales de la cellule mémoire et déposé la couche 152 de SiO₂, on réalise par photolithographie le masque de résine 126, comme représenté sur la figure 25, servant à définir la longueur des canaux des points mémoires ainsi que la largeur des isolations latérales. Ce masque 126 se présente sous la forme de bandes 127 rectilignes, parallèles entre elles et à la direction X de la cellule. Ces bandes ont une largeur de 1400 nm et sont espacées de 1000 nm.

On effectue alors une gravure anisotrope de la couche 152 consistant à éliminer les régions de cette couche non masquée par la résine. Ceci est réalisé par une gravure de type ionique réactive en utilisant un plasma de CHF₃, sur toute l'épaisseur de la couche 152. On obtient ainsi des bandes 201 isolantes parallèles entre elles et à la direction X comme représenté sur la figure 26.

Après élimination du masque 126 avec un plasma d'O₂, on réalise une oxydation thermique des régions sources et drains du substrat mises à nu. La couche d'oxyde 202 présente une épaisseur de 25 nm.

On dépose ensuite une couche 204 d'un matériau que l'on peut graver sélectivement par rapport aux bandes 201 et par exemple une couche de silicium polycristillin non dopé, déposée chimiquement en phase vapeur (CVD), de 1000 nm d'épaisseur puis on dépose une couch 206 de résine de "planarisation", d'environ 500 nm d'épaisseur. Ce dépôt peut être suivi d'un traitement thermique consistant en un chauffage à 200°C pendant une demi-heure afin d'obtenir un bon étalement de la résine.

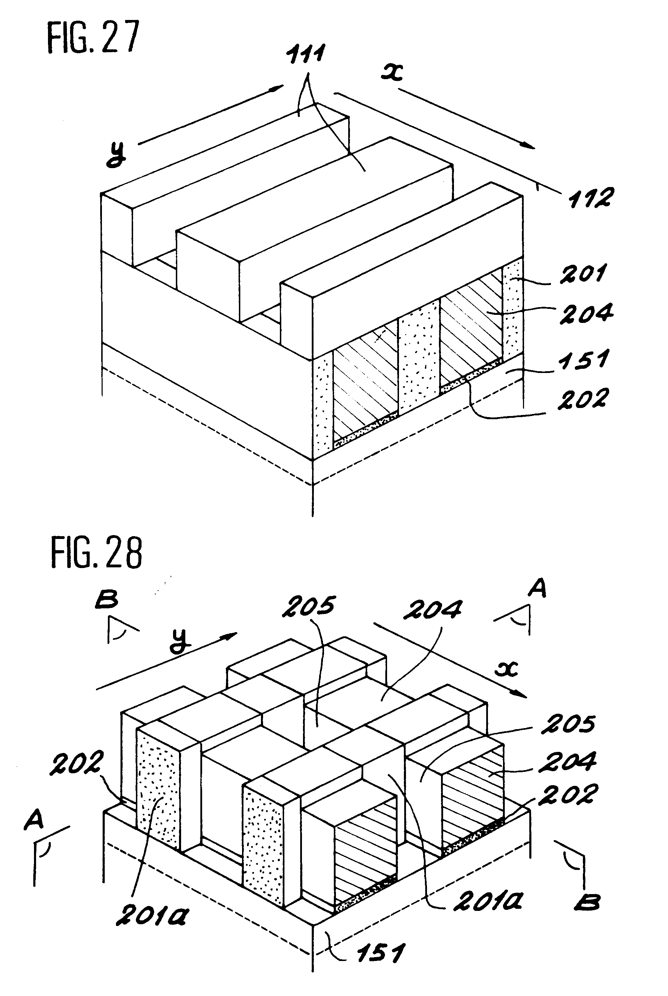

On effectue alors une gravure simultanée de la couche de silicium 204 et d la couche de résine 206 à des vitesses d'attaque identiques pour la résine et le silicium jusqu'à ce que le sommet des bandes isolantes 201 soit mis à nu. La structure obtenue est celle représentée sur la figure 27. Cette gravure est réalisée de façon anisotrope par une gravure ionique réactive utilisant des agents fluorés tels que SF₆ pour le silicium et de l'oxygène pour la résine.

On forme ensuite classiquement par photolithographie le masque de résine 112, représenté sur la figure 27 et définissant la longueur des isolations latérales et la largeur du canal des points mémoires. Ce masque comporte des bandes 111 rectilignes parallèles à la direction Y de la cellule, espacées de 1000 nm et ayant une largeur de 1400 nm.

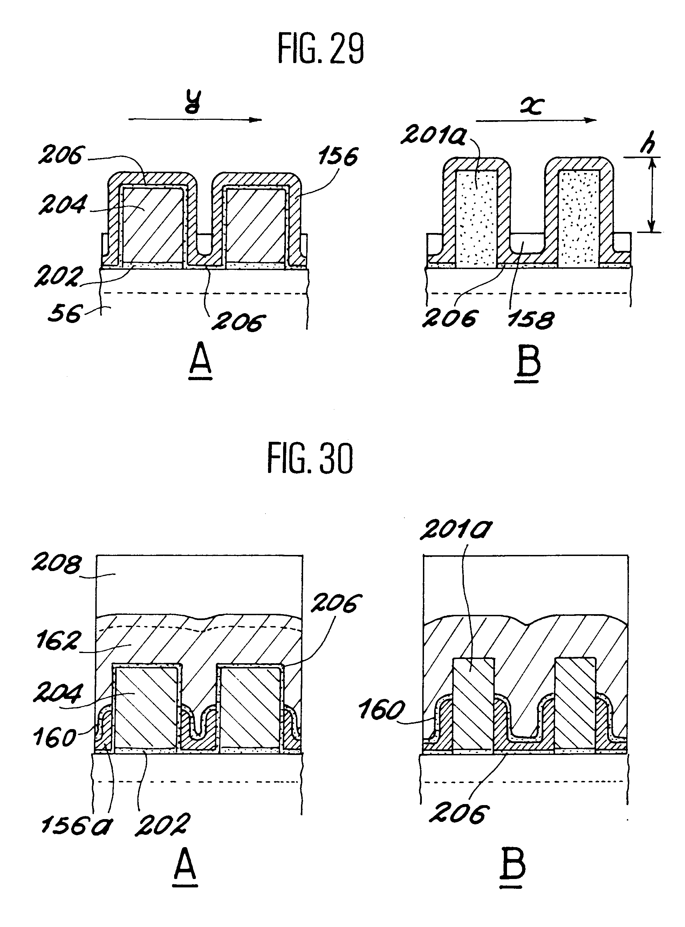

On effectue alors une gravure des bandes isolantes 201 consistant à éliminer les régions de ces bandes non masquées par la résine. Cette gravure est une gravure anisotrope du type ionique réactive utilisant un plasma de CHF₃ ; elle est réalisée sur tout l'épaisseur des bands 201. On obtient ainsi des plots 201a de SiO₂ intercalés entre deux bandes 204 en silicium polycristalllin non dopé selon la direction Y, comme représenté sur la figure 28. Selon la direction X, on trouve une alternance de plots 201a et de trous 205 dans lesquels seront réalisées ultérieuremnt la grille flottante en "cuvette" des points mémoires et leur grille de command. A ce stade de la fabrication, les plots 201a et les bandes 204 présentent la même hauteur.

Après élimination du masque de résine 112, par un plasma O₂, on effectue éventuellement une oxydation thermique à 900°C des régions du substrat en silicium 56 mises à nu (fond des trous 205) et du silicium formant les bandes 204, sur une épaisseur de 25 nm environ. Cette couche d'isolant "sacrificielle" n'est pas représentée sur les figures. On effectue ensuite une gravure de cette couche d'oxyde, par un procédé ionique réactif utilisant un plasma de CHF₃, conduisant à la structure représentée sur la figure 28 dans laquelle les plots 201a sont plus hauts que les bandes 204 en silicium. Le décalage de hauteur est de l'ordre de 25 nm.

On effectue alors une oxydation thermique des régions du substrat mises à nu et du silicium des bandes 204 à 900°C sur une épaisseur de 20 nm environ. La couche obtenue porte la référence 206 elle constitue sur le substrat 56 l'oxyde de grille des points mémoires.

Après formation de la couche d'oxyde 206, on effectue une implantation d'ions de même conductivité que celle du substrat afin de définir le canal des points mémoires. Ceci est obtenu en implantant du bore à une dose de 3.10¹¹ ions/cm² et une énergie de 50 keV.

On effectue, ensuite comme décrit, précédemment en référence aux figures 20 à 23, le dépôt de la couche 156 de silicium polycristallin dopé n+ par diffusion de phosphore sous forme de POCL₃. Cette couche 156 déposée par CVD sur une épaisseur de 250 nm servira à la réalisation ultérieure de la grille flottante des points mémoires.

Après dépôt de la couche de résine photosensible 158 dite de "planarisation" d'une épaisseur de 1500 nm, éventuellement recuite, on effectue une gravure de cette couche de résine afin de ne garder de la résine que dans les partis en creux du relief de la structure comme représenté sur les parties A et B de la figure 29. La hauteur h séparant la résine et le silicium 156 est voisine de 1000 nm.

Dans les mêmes conditions que précédemment, on effectue alors l'élimination des régions de la couche 156 non recouvertes de résine par une gravure anisotrope avec du SF₆, puis l'élimination de la résine 158 restante. La structure résultant est celle rprésentée sur les parties A et B de la figure 30. Les grilles flottantes 156a des points mémoires sont alors achevées.

On réalise ensuite l'isolant inter-grille 160 formé d'un matériau tricouche SiO₂/Si₃N₄/SiO₂ de 25 nm, 15 nm et 5 nm d'épaisseur respectivement. On dépose alors une seconde couche de silicium polycristallin 162, dopé au phosphore par diffusion de POCL₃, par LPCVD. Cette couche 162 de 1000 nm d'épaisseur servira ultérieurement pour la réalisation de la grille de commande des points mémoires.

On dépose ensuite une couche de résine photosensible 208 de 500 nm d'épaisseur afin d'obtenir une structure plane. Ce dépôt est éventuellement suivi d'un traitement thermique à 200°C pendant 1 demi-heure.

On effectue alors une gravure simultanée de la couche de silicium 162 et de la couche de résine 208 jusqu'à l'apparition du sommet des plots 201a de SiO₂. Cette gravure est réalisée avec une gravure du type ionique réactive utilisant un plasma de SF₆ et de O₂ pour attaquer respectivement le silicium polycristallin et la résine.

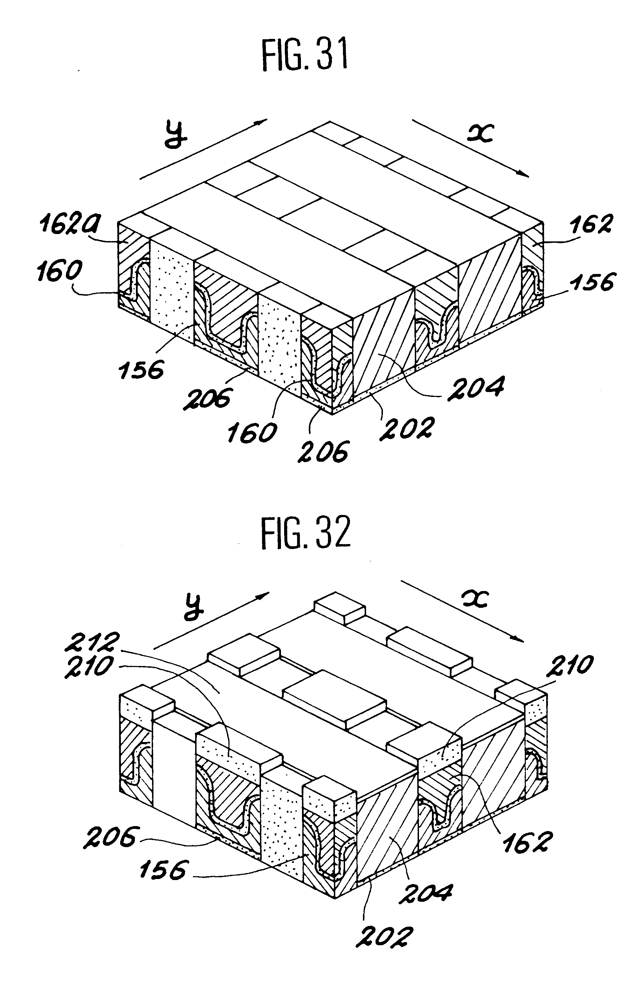

Cette gravure permet en outre d'éliminer les régions de la couche 206 en SiO₂ non recouvertes par l'isolant inter-grille 160 (situées sur les bandes 204) ainsi que l'élimination du sommet des plots 201a d'oxyde. On obtient ainsi une structure plane telle que représentée sur la figure 31. Les grilles de commandes 162a des points mémoires sont alors achevées.

On effectue alors une oxydation thermique différentielle du silicium polycristallin dopé 162 et du silicium polycristallin non dopé 204. Cette oxydation est réalisée sous vapeur d'eau à 850°C pendant 1 heure ce qui permet de faire croître environ 200 nm d'oxyde 210 sur le silicium polycristallin dopé 162 et seulement 50 nm d'oxyde 212 sur le silicium polycristallin non dopé 204, comme représenté sur la figure 32. L'obtention d'un couche d'oxyde plus épaisse sur le silicium dopé 162 tient au fait que ce dernier s'oxyde 4 fois plus rapidement que le silicium 204 non dopé.

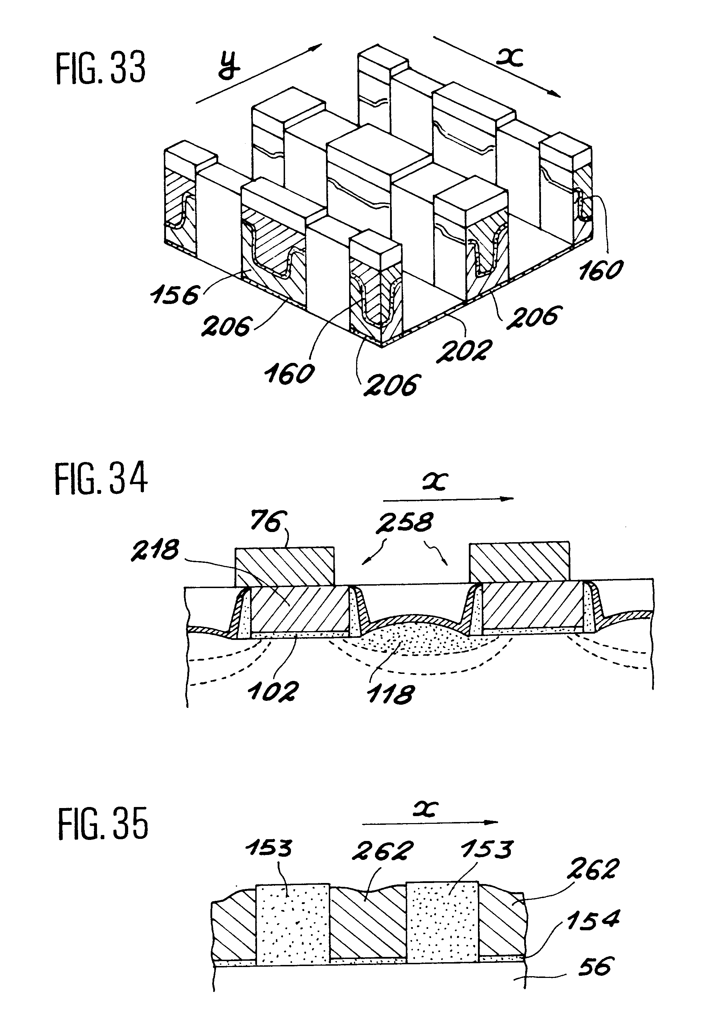

On effectue alors une gravure plein plaque de l'oxyde formé sur une épaisseur de 50 nm par gravure ionique réactive avec du CHF₃ entraînant en particulier, l'élimination de l'oxyde 212 surmontant le silicium non dopé 204. On effectue alors l'élimination du silicium polycristallin non dopé 204 par une gravure ionique réactive sélective en utilisaant un plasma de SF₆ sous "haute pression" par exemple 130 Pa (1 torr). La structure obtenue est celle représenté sur la figure 33.

Ce procédé se poursuit comme précédemment par dépôt de la couche d'oxyde 130 dans laquelle seront réalisés les espaceurs 131 (figure 11). La gravure de cette couche 130 permet, de plus, l'élimination de l'isolant 202 situé sur les zones de sources et de drains. Les étapes ultérieures sont identiques à celles décrites en référence aux figures 12 à 18.

Ce procédé permet l'obtention d'une cellule mémoire EPROM dans laquelle les grilles flottantes 156a présentent la forme d'un U aussi bien dans la direction Y que dans la direction X de la cellule. Cette forme en cuvette de la grille flottante améliore de façon considérable le couplage entre la grille flottante 156a et la grille de commande 162a de chaque point mémoire améliorant ainsi les propriétés électriques de la cellule mémoire.

Bien entendu, cette cellule mémoire à grille flottante en cuvette peut être équipée de tranchées d'isolement telles que décrites en référence à la figure 3.

La description ci-dessus ne se réfère qu'à la fabrication de la cellule mémoire (ou mémoire proprement dite) d'une mémoire EPROM. La réalisation des circuits périphériques de commande de la mémoire situés dans le même plan que la cellule mémoire, nécessite bien entendu l'utilisation d'autres masques de résine photolithographiques que ceux décrits précédemment, mais ces masques ne sont absolument pas critiques.

La description ci-dessus n'a bien entendu été donnée qu'à titre d'exemple, toute modification sans pour autant sortir du cadre de l'invention pouvant être envisagé.

En particulier, il est possible de modifier l'épaisseur des différentes couches, de remplacer les couches isolantes d'oxyde de silicium par des couches de nitrure de silicium, de remplacer les couches conductrices en silicium polycristallin dopé n+ (par du phosphore notamment) par des couches en silicium polycristallin dopé p+ (bore par exemple) ou encore par d'autres matériaux conducteurs tels que des matériaux réfractaires ou des siliciures.

De même, il est possible de remplacer toutes les gravures ioniques réactives par d'autres types de gravures sèches ou humides généralement utilisés en microélectronique. Par exemple, pour des couches réalisées en des matériaux difficiles à graver, ce qui est le cas pour des couches en cuivre ou en argent, on peut utiliser des usinages ioniques.

Il est aussi possible de réaliser une mémoire EPROM sur un substrat semiconducteur autre que du silicium (GaAs, InP par exemple) ainsi que d'utiliser un substrat dopé n. Dans le cas d'un substrat de silicium dopé n, les dopages au bore doivent être remplacés par des dopages d'arsenic ou de phosphore et inversement les dopages d'arsenic ou de phosphore doivent être remplacés par des dopages de bore.

Par ailleurs, comme indiqué précédemment, l'invention s'applique à tout circuit intégré comportant un ensemble de transistors MIS pas forcément répartis en matrice, comportant chacun soit une grille de commande et une grille flottante, soit uniquement une grille de commande ; l'invention est particulièrement bien adaptée aux cellules mémoires non volatiles autres que les EPROM telles que les EEPROM, les REPROM et les ROM ; ces mémoires présentent généralement la même organisation (adressage) que les mémoires EPROM.

A cet effet, on a représenté sur les figures 34 et 35 des transistors MOS conformes à l'invention ne comportant pas de grille flottante (mémoire ROM par exemple). Les figures 34 et 35 sont comparables respectivement aux figures 15 et 23.

La figure 34 se différencie de la figure 15 par l'absence de couche isolante 104 et la mise en court-circuit des couches 106 et 108 et donc à la présence d'une couche conductrice unique 218 en silicium polycristallin constituant la grille du transistor ; ceci correspond à la suppression de l'isolant inter-grille et de la grille flottante. La référence 258 correspond l'empilement de l'isolant de grille 102 et de la grille 218.

La fabrication de ce transistor MOS est identique à celle de la cellule mémoire EPROM (figures 4-15) à l'exception du dépôt et des gravures d'une couche unique de silicium polycristallin 218 dopé au phosphore, de 1300 nm environ d'épaisseur au lieu des dépôts et gravures successifs des couches 104, 106 et 108.

Dans le cas d'une matrice de transistors, un sur deux des transistors peut être équipé d'une tranchée d'isolement comme décrit sur la figure 3.

De la même façon, la figure 35 se différencie de la figure 23 par l'absence de la couche isolante 160 et le remplacement des couches conductrices 156 et 162 par une couche unique 262 de silicium polycristallin constituant la grille du transistor. La fabrication de ce transistor (en dehors des dépôts et gravures des empilements de grilles) est identique à celle décrite en référence aux figures 19-23.

## Revendications

1. Circuit intégré sur un substrat semiconducteur (56), comportant (a) un ensemble de transistors (50) isolés électriquement et latéralement les uns des autres par des isolations latérales, chaque transistor comprenant un premier empilement (58, 258) de matériaux formé d'un premier isolant (60, 102, 154), en contact avec le substrat, et d'au moins une grille (62, 164, 218, 262, 156a) au contact du premier isolant, une source (52) et un drain (54) formés dans le substrat (56) de part et d'autre de l'empilement (58, 258) et un canal, situé dans le substrat sous ledit empilement, dont la longueur est orientée selon une première direction (Y) allant de la source au drain, (b) des premières lignes conductrices (76) d'axe longitudinal parallèle à une seconde direction pour appliquer des premiers signaux électriques sur lesdits empilements (58, 258), (c) des secondes lignes conductrices (78) d'axe longitudinal parallèle à une troisième direction (X) pour appliquer des seconds signaux électriques sur les drains (54) et (d) des troisièmes lignes conductrices (80) d'axe longitudinal parallèle à la troisième direction pour appliquer des troisièmes signaux électriques sur les sources (52), la seconde direction étant confondue avec la première direction (Y) et la troisième direction (X) étant perpendiculaire à la première direction, caractérisé en ce que les secondes et troisièmes lignes conductrices sont réalisées directement sur respectivement les drains et les sources.

2. Circuit intégré selon la revendication 1, caractérisé en ce que les grilles et les premières lignes conductrices sont réalisées indépendamment en des matériaux différents.

3. Circuit intégré selon la revendication 1 ou 2, caractérisé en ce que les premières lignes conductrices (76) sont réalisées en métal.

4. Circuit intégré selon la revendication 1, caractérisé en ce que les premières lignes conductrices (76, 276) sont réalisées en aluminium.

5. Circuit intégré selon l'une quelconque des revendications 1 à 4, caractérisé en ce que les secondes et troisièmes lignes conductrices (78, 80) sont réalisées en métal ou en siliciure d'un métal réfractaire.

6. Cellule mémoire intégrée sur un substrat semiconducteur (56), comportant (a) un ensemble de points mémoires (50) isolés électriquement et latéralement les uns des autres par des isolations latérales, caractérisée en ce qu'elle consiste en un circuit intégré selon l'une quelconque des revendications 1 à 4 dans lequel les transistors constituent lesdits points mémoires et les empilements de matériaux de ces transistors comprennent une première (62, 164, 156a) et une seconde (66, 168, 162a) grilles, séparées l'une de l'autre par un second isolant (64, 160), la première grille étant au contact du premier isolant.

7. Cellule mémoire selon la revendication 6, caractérisée en ce que les secondes et troisièmes lignes (78, 80) conductrices sont réalisées en métal ou en siliciure d'un métal réfractaire.

8. Cellule mémoire selon la revendication 6 ou 7, caractérisée en ce que la première (62, 164) et la seconde (66, 168) grilles des points mémoires ont la même largeur et la même longueur.

9. Cellule mémoire selon l'une quelconque des revendications 6 à 8, caractérisée en ce que ta première (62, 164) et la seconde (66, 168) grilles des points mémoires ne s'étendent pas au-dessus des isolations latérales (118, 125, 148, 153) servant à isoler électriquement les points mémoires entre eux.

10. Cellule mémoire selon l'une quelconque des revendications 6 à 9, caractérisée en ce que la première grille (164) présente au moins selon une coupe parallèle à la troisième direction (X) la forme d'un U.

11. Cellule mémoire selon la revendication 10, caractérisée en ce que la première grille (156a) présente selon une coupe parallèle à la troisième direction (X) et selon une coupe parallèle à la seconde direction (Y) la forme d'un U.

12. Cellule mémoire selon l'une quelconque des revendications 6 à 11, caractérisée en ce qu'elle comprend, en outre, des seconds empilements (82) de matériaux formés chacun d'un troisième isolant (84) en contact avec le substrat (56), d'un quatrième (86) et cinquième (90) matériaux conducteurs, séparés l'un de l'autre par un sixième matériau isolant (88), le quatrième matériau étant au contact du troisième isolant, chaque second empilement (82) étant intercalé entre deux points mémoires (50a, 50b) selon la première direction (Y), une tranchée d'isolement (92) formée dans le substrat (56) étant prévue sous chaque second empilement (82).

13. Procédé de fabrication d'un circuit intégré selon la revendication 1, caractérisé en ce qu'il ne comporte que trois niveaux de masquage lithographique (112, 126, 144), un premier masque (112) pour définir simultanément la largeur des canaux ainsi que la longueur des isolations latérales, un second masque (126) pour définir simultanément la largeur des isolations latérales, ainsi que la longueur des canaux, et un troisième (144) masque pour définir les premières lignes conductrices (76) et en ce que les secondes et troisièmes lignes conductrices sont réalisées directement et respectivement sur les drains et sources.

14. Procédé de fabrication selon la revendication 13, caractérisé en ce que le premier (112), second (126) et troisième (144) masques sont formés chacun de bandes rectilignes (111, 127, 145) de largeur constante et équidistantes, les bandes (111, 145) du premier et troisième masques étant perpendiculaires à celles du second masque.

15. Procédé de fabrication selon la revendication 13 ou 14, caractérisé en ce qu'il comprend les étapes suivantes :
(1) dépôts successifs sur le substrat (56) d'une couche (102) d'un premier matériau isolant, et d'une couche (218) d'un second matériau conducteur,
(2) réalisation du premier masque (112),
(3) élimination des régions du second et éventuellement premier matériaux, non masquées par le premier masque, formant ainsi des premières bandes (113) en surplomb parallèles à une première direction (Y),
(4) élimination du premier masque (112),
(5) remplissage des espaces définis entre les premières bandes (113) par un troisième matériau isolant (118, 122, 148), constituant les isolations latérales,
(6) réalisation du second masque (126),
(7) élimination des régions des troisième, second et éventuellement premier matériaux, non masquées par le second masque, formant ainsi des secondes bandes (58-128) en surplomb parallèles à une seconde direction (X) perpendiculaire à la première direction,
(8) réalisation des sources (52) et des drains (54) par un premier dopage du substrat (56) ayant une conductivité de type inverse de celle du substrat,
(9) élimination du second masque (126),
(10) réalisation d'espaceurs isolants (131) de part et d'autre des secondes bandes (58-128), accolés à ces secondes bandes,
(11) réalisation des secondes lignes conductrices (78) dans les espaces définis entre les espaceurs (131), la hauteur des secondes lignes étant inférieure à celle des secondes bandes et des espaceurs,
(12) recouvrement des secondes lignes conductrices (78) par un quatrième matériau isolant (138) affleurant le sommet des secondes bandes (58-128),
(13) dépôt d'une couche de cinquième matériau conducteur (142) sur toute la structure obtenue,
(14) réalisation du troisième masque (144),
(15) élimination des régions de cinquième matériau non masquées par le troisième masque, formant ainsi les premières lignes conductrices (76) et,
(16) élimination du troisième masque (144).

16. Procédé de fabrication selon la revendication 15, caractérisé en ce que l'on effectue un second dopage du substrat (56) ayant le même type de conductivité que celui du substrat, après dépôt du premier matériau, pour définir le dopage (101) des canaux.

17. Procédé de fabrication selon la revendication 15 ou 16, caractérisé en ce que l'on dépose, au cours de l'étape (1), une couche (110) d'un sixième matériau isolant sur la couche de second (218) matériau et en ce que cette couche de sixième matériau est gravée lors des étapes (3) et (7).

18. Procédé de fabrication selon la revendication 17, caractérisé en ce qu'entre les étapes (4) et (5) on recouvre le dessus et les flancs gravés des premières bandes (113) d'un septième matériau isolant (116), et en ce que l'on oxyde thermiquement (118) le substrat (56) situé entre ces flancs gravés, le substrat étant réalisé en silicium.

19. Procédé selon la revendication 13 ou 14 appliqué à la fabrication d'une cellule mémoire intégrée sur un substrat semiconducteur (56) comportant (a) un ensemble de points mémoires (50) isolés électriquement les uns des autres par des isolations latérales (118, 125, 148, 153), chaque point mémoire consistant en un transistor comprenant entre autres au moins une première (62, 164, 156a) et une seconde (66, 168, 162a) grilles empilées, isolées l'une de l'autre, caractérisé en ce qu'il comprend les étapes suivantes :
(1) dépôts successifs sur le substrat (56) d'une couche (102) d'un premier matériau isolant, et d'une couche (104) d'un second matériau conducteur, d'une couche (106) de troisième matériau isolant et d'une couche (108) d'un quatrième matériau conducteur,
(2) réalisation du premier masque (112),
(3) élimination des régions des quatrième, troisième, second et éventuellement premier matériaux, non masquées par le premier masque, formant ainsi des premières bandes (113) en surplomb parallèles à une première direction (Y),
(4) élimination du premier masque (112),
(5) remplissage des espaces définis entre les premières bandes (113) par un cinquième matériau isolant (118, 122, 148), constituant les isolations latérales,
(6) réalisation du second masque (126),
(7) élimination des régions des cinquième, quatrième, troisième, second et éventuellement premier matériaux, non masquées par le second masque, formant ainsi des secondes bandes (58-128) en surplomb parallèles à une seconde direction (X) perpendiculaire à la première direction,
(8) réalisation des sources (52) et des drains (54) par un premier dopage du substrat (56) ayant une conductivité de type inverse de celle du substrat,
(9) élimination du second masque (126),
(10) réalisation d'espaceurs isolants (131) de part et d'autre des secondes bandes (58-128), accolés à ces secondes bandes,
(11) réalisation des secondes lignes conductrices (78) dans les espaces définis entre les espaceurs (131), la hauteur des secondes lignes étant inférieure à celle des secondes bandes et des espaceurs,
(12) recouvrement des secondes lignes conductrices (78) par un sixième matériau isolant (138) affleurant le sommet des secondes bandes (58-128),
(13) dépôt d'une couche de cinquième matériau conducteur (142) sur toute la structure obtenue,
(14) réalisation du troisième masque (144),
(15) élimination des régions de septième matériau non masquées par le troisième masque, formant ainsi les premières lignes conductrices (76) et,
(16) élimination du troisième masque (144).

20. Procédé selon la revendication 13 ou 14, caractérisé en ce qu'il comprend les étapes suivantes :
(I) dépôt d'une couche (152) d'un premier matériau isolant sur l'ensemble du substrat (56) pour former les isolations latérales,
(II) réalisation du premier masque (112),
(III) élimination des régions de premier matériau non masquées par le premier masque (112), formant ainsi des premières bandes (153) en surplomb parallèles à une première direction (Y),
(IV) élimination du premier masque (112),
(V) dépôt d'un second matériau isolant (154) entre les premières bandes (153),
(VI) dépôts uniquement sur le second matériau (154), d'un troisième matériau conducteur (262), la hauteur de l'empilement de second et troisième matériaux étant voisine de celle des premières bandes (153),
(VII) réalisation du second masque (126),
(VIII) élimination des régions de troisième et éventuellement second matériaux non masquées par le second masque, formant ainsi des secondes bandes (58-128) en surplomb parallèles à une seconde direction (X) perpendiculaire à la première direction,
(IX) réalisation des sources (52) et des drains (54) par un premier dopage du substrat (56) ayant une conductivité de type inverse de celle du substrat,
(X) élimination du second masque (126),
(XI) réalisation d'espaceurs isolants (131) de part et d'autre des secondes bandes (58-128), accolés à ces secondes bandes,
(XII) réalisation des secondes lignes conductrices (78) dans les espaces définis entre les espaceurs (131), la hauteur des secondes lignes étant inférieure à celle des secondes bandes et des espaceurs,
(XIII) recouvrement des secondes lignes conductrices (78) par un quatrième matériau isolant (138), affleurant le sommet des secondes bandes (58-128),
(XIV) dépôt d'une couche de cinquième matériau conducteur (142) sur toute la structure obtenue,
(XV) réalisation du troisième masque (144),
(XVI) élimination des régions de cinquième matériau non masquées par le troisième masque, formant ainsi les premières lignes conductrices (76), et
(XVII) élimination du troisième masque (144).

21. Procédé selon la revendication 13 ou 14, appliqué à la fabrication d'une cellule mémoire intégrée sur un substrat semiconducteur (56) comportant (a) un ensemble de points mémoires (50) isolés électriquement les uns des autres par des isolations latérales (118, 125, 148, 153), chaque point mémoire consistant en un transistor comprenant entre autres au moins une première grille (62, 164, 156a) et une seconde grille (66, 168, 162a) empilées, isolées l'une de l'autre, caractérisé en ce qu'il comprend les étapes suivantes :
(I) dépôt d'une couche (152) d'un premier matériau isolant sur l'ensemble du substrat (56) pour former les isolations latérales,
(II) réalisation du premier masque (112),
(III) élimination des régions de premier matériau non masquées par le premier masque (112), formant ainsi des premières bandes (153) en surplomb parallèles à une première direction (Y),
(IV) élimination du premier masque (112),
(V) dépôt d'un second matériau isolant (154) entre les premières bandes (153),
(VI) dépôts successifs uniquement sur le second matériau (154), d'un troisième matériau conducteur (156), d'un quatrième matériau isolant (160), d'un cinquième matériau conducteur (162), la hauteur de l'empilement de second, troisième, quatrième et cinquième matériaux étant voisine de celle des premières bandes (153),
(VII) réalisation du second masque (126),
(VIII) élimination des régions de cinquième, quatrième, troisième et éventuellement second matériaux non masquées par le second masque, formant ainsi des secondes bandes (58-128) en surplomb parallèles à une seconde direction (X) perpendiculaire à la première direction,
(IX) réalisation des sources (52) et des drains (54) par un premier dopage du substrat (56) ayant une conductivité de type inverse de celle du substrat,
(X) élimination du second masque (126),
(XI) réalisation d'espaceurs isolants (131) de part et d'autre des secondes bandes (58-128), accolés à ces secondes bandes,
(XII) réalisation des secondes lignes conductrices (78) dans les espaces définis entre les espaceurs (131), la hauteur des secondes lignes étant inférieure à celle des secondes bandes et des espaceurs,
(XIII) recouvrement des secondes lignes conductrices (78) par un sixième matériau isolant (138), affleurant le sommet des secondes bandes (58-128),
(XIV) dépôt d'une couche de septième matériau conducteur (142) sur toute la structure obtenue,
(XV) réalisation du troisième masque (144),
(XVI) élimination des régions de septième matériau non masquées par le troisième masque, formant ainsi les premières lignes conductrices (76), et
(XVII) élimination du troisième masque (144).

22. Procédé selon la revendication 13 ou 14, appliqué à la fabrication d'une cellule mémoire intégrée sur un substrat semiconducteur (56) comportant (a) un ensemble de points mémoires (50) isolés électriquement les uns des autres par des isolations latérales (118, 125, 148, 153), chaque point mémoire consistant en un transistor comprenant entre autres au moins une première (62, 164, 156a) et une seconde (66, 168, 162a) grilles empilées, isolées l'une de l'autre, caractérisé en ce qu'il comprend les étapes suivantes :
(A) dépôt d'une couche (152) d'un premier matériau isolant sur l'ensemble du substrat (56) pour former les isolations latérales,
(B) réalisation du second masque (126),
(C) élimination des régions de premier matériau non masquées par le second masque (126), formant ainsi des premières bandes (201) en surplomb parallèles à une première direction (X),
(D) élimination du second masque (126),
(E) dépôt d'un matériau intermédiaire (204) entre les premières bandes (201) que l'on peut graver sélectivement par rapport au premier matériau,
(F) réalisation du premier masque (112),
(G) élimination des régions de premier matériau non masquées par le premier masque (112), formant ainsi des secondes bandes (201a-204) en surplomb parallèles à une seconde direction (Y),
(H) élimination du premier masque (112),
(I) dépôt d'un second matériau isolant (206) entre les secondes bandes (201a-204),
(J) dépôts successifs entre les secondes bandes d'un troisième matériau conducteur (156), d'un quatrième matériau isolant (160), d'un cinquième matériau conducteur (162), la hauteur de l'empilement de second, troisième, quatrième et cinquième matériaux étant voisine de celle des secondes bandes,
(K) élimination du matériau intermédiaire (204),
(L) réalisation des sources (52) et des drains (54) par un premier dopage du substrat (56) ayant une conductivité de type inverse de celle du substrat,
(M) réalisation d'espaceurs isolants (131) de part et d'autre des secondes bandes (201a-204) accolés à ces secondes bandes,
(N) réalisation des secondes lignes conductrices (78) dans les espaces définis entre les espaceurs (131), la hauteur des secondes lignes étant inférieure à celle des secondes bandes et des espaceurs,
(O) recouvrement des secondes lignes conductrices (78) par un sixième matériau isolant (138), affleurant le sommet des secondes bandes,
(P) dépôt d'une couche de septième matériau conducteur (142) sur toute la structure obtenue,
(Q) réalisation du troisième masque (144),
(R) élimination des régions de septième matériau non masquées par le troisième masque, formant ainsi les premières lignes conductrices (76), et
(S) élimination du troisième masque (144).

23. Procédé de fabrication selon la revendication 20, 21 ou 22, caractérisé en ce que l'on effectue un second dopage du substrat (56) ayant le même type de conductivité que celui du substrat, entre les dépôts de second et troisième matériaux.

24. Procédé de fabrication selon l'une quelconque des revendications 20 à 23, caractérisé en ce que le substrat (56) étant en silicium, le dépôt de second matériau (154) est réalisé par oxydation thermique du substrat.

25. Procédé de fabrication selon l'une quelconque des revendications 21 à 24, caractérisé en ce que le troisième matériau conducteur (156) étant du silicium, le quatrième matériau isolant (160) est obtenu, tout ou partie, par oxydation thermique de ce troisième matériau.

26. Procédé de fabrication selon l'une quelconque des revendications 21 à 25, caractérisé en ce que l'on dépose sur l'ensemble de la structure une couche du cinquième matériau (162) et en ce que l'on effectue une gravure de cette couche jusqu'à dégagement de dessus des premières bandes (153), afin de n'obtenir du cinquième matériau conducteur qu'au-dessus du second matériau.

27. Procédé de fabrication selon l'une quelconque des revendications 15, 19 à 22, caractérisé en ce que le substrat (56) étant réalisé en silicium et comportant des régions mises à nu, l'étape de réalisation des secondes lignes conductrices (76) comprend les opérations suivantes :
- dépôt sur l'ensemble de la structure d'une couche (146) d'un dixième matériau apte à former un siliciure,
- recuit thermique de l'ensemble afin de faire réagir ce dixième matériau directement au contact des régions du substrat mises à nu pour former localement un siliciure, et
- élimination du dixième matériau n'ayant pas réagi avec le substrat.

28. Procédé de fabrication selon l'une quelconque des revendications 15 à 26, caractérisé en ce que l'étape de réalisation des secondes lignes conductrices (76) comprend les opérations suivantes :
- dépôt d'une couche d'au moins un onzième matériau (132, 134) conducteur sur l'ensemble de la structure,
- dépôt sur tout le onzième matériau d'une troisième couche (136) de résine effaçant le relief du onzième matériau,
- éventuellement traitement thermique de la troisième couche de résine (136),
- gravure de la troisième couche de résine (136) afin de ne garder de la résine que dans les parties en creux du relief du onzième matériau,
- élimination des régions de onzième matériau non recouvertes de résine, et
- élimination du restant de la troisième couche de résine (136).

29. Procédé de fabrication selon la revendication 28, caractérisé en ce que la couche de onzième matériau est formée d'une couche de TiW, recouverte d'une couche d'aluminium.

30. Procédé de fabrication selon la revendication 28, caractérisé en ce que la couche de onzième matériau est formée d'une couche de titane.

31. Procédé de fabrication selon l'une quelconque des revendications 15 à 30, caractérisé en ce que l'on effectue sous les isolations latérales (118, 125, 148, 153) un troisième dopage du substrat ayant le même type de conductivité que celui du substrat (56).

## Claims

1. Integrated circuit on a semiconductor substrate (56), comprising (a) a group of transistors (50) insulated electrically and laterally with respect to one another by lateral insulants, each transistor comprising a first stack (58, 258) of materials formed from a first insulant (60, 102, 154), in contact with the substrate, and at least one gate (62, 164, 218, 262, 156a) in contact with the first insulant, a source (52) and a drain (54) formed in the substrate (56) on either side of the stack (58, 258) and a channel, located in the substrate beneath said stack, whose length is oriented in a first direction (Y) passing from the source to the drain, (b) first longitudinally axed conductor lines (76) parallel to a second direction for applying first electric signals to said stacks (58, 258), (c) second longitudinally axed conductor lines (78) parallel to a third direction for applying second electric signals to the drains (54) and (d) third longitudinally axed conductor lines (80) parallel to the third direction for applying third electric signals to the sources (52), the second direction coinciding with the first direction (Y), the third direction (X) heing perpendicular to the first direction, characterized in that the second and third conductor lines are directly produced on respectively the drains and sources.

2. Integrated circuit according to claim 1, characterized in that the gates and the first conductor lines are produced independently from different materials.

3. Integrated circuit according to claim 1 or 2, characterized in that the first conductor lines (76) are made from metal.

4. Integrated circuit according to claim 1, characterized in that the first conductor lines (76, 276) are made from aluminium.

5. Integrated circuit according to any one of the claims 1 to 4, characterized in that the second and third conductor lines (78, 80) are made from metal or a silicide of a refractory metal.

6. Integrated memory cell on a semiconductor substrate (56) incorporating (a) a group of memory points (50) insulated electrically and laterally from one another by lateral insulants, characterized in that it comprises an integrated circuit according to any one of the claims 1 to 4, in which the transistors constitute the said memory points and the stacks of materials of said transistors incorporate first (62, 164, 156a) and second (66, 168, 162a) gates, separated from one another by a second insulant (64, 160), the first gate being in contact with the first insulant.

7. Memory cell according to claim 6, characterized in that the second and third conductor lines (78, 80) are made from metal or a silicide of a refractory metal.

8. Memory cell according to claim 6 or 7, characterized in that the first (62, 164) and second (66, 168) gates of the memory points have the same width and the same length.

9. Memory cell according to any one of the claims 6 to 8, characterized in that the first (62, 164) and second (66, 168) gates of the memory points do not extend above the lateral insulations (118, 125, 148, 153) serving to electrically insulate the memory points from one another.

10. Memory ell according to any one of the claims 6 to 9 characterized in that the first gate (164) is shaped like a U at least in a section parallel to the third direction (X).

11. Memory cell according to claim 10, characterized in that the first gate (156a) in a section parallel to the third direction (X) and in a section parallel to the second direction (Y) is shaped like a U.

12. Memory cell according to any one of the claims 6 to 11 characterized in that it also comprises second stacks (82) of materials,, each formed by a third insulant (84) in contact with the substrate (56), a fourth (86) and fifth (90) conductive materials separated from one another by a sixth insulating material (88), the fourth material being in contact with the third insulant, each second stack (82) being inserted between two memory points (50a, 50b) in the first direction (Y), an insulating trench (92) formed in the substrate (56) being provided beneath each second stack (82).

13. Process for the manufacture of an integrated circuit according to claim 1, characterized in that it only has three lithographic masking levels (112, 126, 144), a first mask (112) for simultaneously defining the width of the channels and the length of the lateral insulations, a second mask (126) for simultaneously defining the width of the lateral insulations, as well as the length of the channels and a third mask (144) for defining the first conductor lines (76) and in that the second and third conductor lines are produced directly and respectively on the drains and sources.

14. Manufacturing process according to claim 13, characterized in that the first (112), second (126) and third (144) masks are in each case formed from rectilinear strips (111, 127, 145) of constant width and which are equidistant, the strips (111, 145) of the first and third masks being perpendicular to those of the second mask.

15. Manufacturing process according to claim 13 or 14, characterized in that it comprises the following stages:
(1) successive depositions on the substrate (56) of a layer (102) of a first insulating material and a layer (218) of a second conductive material,
(2) production of the first mask (112),
(3) elimination of the regions of the second and possibly first materials not masked by the first mask and thus forming first overhanging strips (113) parallel to a first direction (Y),
(4) elimination of the first mask (112),
(5) filling the spaces defined between the first strips (113) by a third insulating material (118, 122, 148) constituting the lateral insulations,
(6) production of the second mask (126),
(7) elimination of the regions of the third, second and possibly first materials, not masked by the second mask, thus forming second over-hanging strips (58-128) parallel to a second direction (X) perpendicular to the first direction,
(8) production of sources (52) and drains (54) by a first doping of the substrate (56) having a reverse conductivity to that of the substrate,
(9) elimination of the second mask (126),
(10) production of insulating spacers (131) on either side of the second strips (58-128) and joined to the latter,
(11) production of second conductor lines (78) in the spaces defined between the spacers (131), the height of the second lines being less than that of the second strips and the spacers,
(12) covering the second conductor lines (78) by a fourth insulating material (138) level with the top of the second strips (58-128),
(13) deposition of a layer of the fifth conductive material (142) over the entire structure obtained,
(14) production of the third mask (144),
(15) elimination of the regions of the fifth material not masked by the third mask, thus forming the first conductor lines (76) and
(16) elimination of the third mask (144).

16. Manufacturing process according to claim 15, characterized in that there is a second doping of the substrate with the same type of conductivity as that of the substrate, following the deposition of the first material and in order to define the doping (101) of the channels.

17. Manufacturing process according to claim 15 or 16, characterized in that during stage (1) a layer (110) of a sixth insulating material is deposited on the second material (218) and in that said sixth material layer is etched during stages (3) and (7).

18. Manufacturing process according to claim 17, characterized in that between stages (4) and (5), the top and etched edges of the first strips (113) are covered with a seventh insulating material (116) and in that the substrate (56) located between said etched edges is thermally oxidized (118), the substrate being made from silicon.

19. Process according to claim 13 or 14, applied to the manufacture of a memory cell integrated on a semiconductor substrate (56) comprising (a) a group of memory points (50) electrically insulated from one another by lateral insulations (118, 125, 148, 153), each memory point having at least one first (62, 164, 156a) and one second (66, 168, 162a) stacked gates, which are insulated from one another, characterized in that it comprises the following stages:
(1) successive depositions on the substrate (56) of a layer (102) of a first insulating material and a layer(104) of a second conductive material, a layer (106) of a third insulating material and a layer (108) of a fourth conductive material,
(2) production of the first mask (112),
(3) elimination of the regions of the fourth, third, second and possibly first materials not masked by the first mask, thus forming the first overhanging strips (113) parallel to a first direction (Y),
(4) elimination of the first mask (112),
(5) filling the spaces defined between the first strips (113) with a fifth insulating material (118, 122, 148) constituting the lateral insulations,
(6) production of the second mask (126),
(7) elimination of the regions of the fifth, fourth, third, second and possibly first materials not masked by the second mask, thus forming second overhanging strips (58-128) parallel to a second direction (X) perpendicular to the first direction,
(8) production of the sources (52) and drains (54) by a first doping of the substrate (56) having a conductivity which is the opposite to that of the substrate,
(9) elimination of the second mask (126),
(10) production of insulating spacers (131) on either side of the second strips (58-128) and joined to the latter,
(11) production of second conductor lines (78) in the spaces defined between the spacers (131), the height of the second lines being less than that of the second strips and the spacers,
(12) covering the second conductor lines (78) by a sixth insulating material (138) level with the top of the second strips (58-128),
(13) deposition of a layer of a fifth conductive material (142) on the entire structure obtained,
(14) production of the third ask (144),
(15) elimination of the regions of the seventh material not masked by the third mask, thus forming first conductor lines (76) and,
(16) elimination of the third mask (144).

20. Process according to claim 13 or 14, characterized in that it comprises the following stages:
(I) deposition of a layer (152) of a first insulating material on the complete substrate (56) for forming the lateral insulations,
(II) production of the first mask (112),
(III) elimination of the regions of the first material not masked by the first first mask (112), thus forming first overhanging strips (153) parallel to a first direction (Y),
(IV) elimination of the first mask (112),
(V) deposition of a second insulating material (154) between the first strips (153),
(VI) deposition solely on the second material (154) of a third conductive material (262), the height of the stack of the second and third materials being close to that of the first strips (153),
(VII) production of the second mask (126),
(VIII) elimination of the regions of the third and possibly second materials not masked by the second mask, thus forming the second overhanging strips (58-128) parallel to a second direction (X) perpendicular to the first direction,
(IX) production of sources (52) and drains (54) by a first doping of the substrate (56) having a reverse conductivity to that of the substrate,
(X) elimination of the second mask (126),
(XI) production of insulating spacers (131) on either side of the second strips and joined to the latter,
(XII) production of second conductor lines (78) in the spaces defined between the spacers (131), the height of the second lines being less than that of the second strips and the spacers,
(XIII) covering the second conductor lines (78) by a fourth insulating material (138) level with the top of the second strips (58-128),
(XIV) deposition of a layer (142) of a fifth conductive material on the entire structure obtained,
(XV) production of the third mask (144),
(XVI) elimination of the regions of the fifth material not masked by the third mask, thus forming the first conductor lines (76) and,
(XVII) elimination of the third mask (144).

21. Process according to claim 13 or 14, applied to the manufacture of a memory cell integrated on a semiconductor substrate (56) comprising (a) a group of memory points (50) electrically insulated from one another by lateral insulations (118, 125, 148, 153), each memory point consisting of a transistor inter alia incorporating at least one first gate (62, 164, 156a) and one second gate (66, 168, 162a), which are stacked and insulated from one another, characterized in that it comprises the following stages:
(I) deposition of a first layer (152) of a first insulating material on the complete substrate (56) for forming lateral insulations,
(II) production of the first mask (112),
(III) elimination of the regions of the first material not masked by the first mask (112), thus forming first overhanging strips (153) parallel to a first direction (Y),
(IV) elimination of the mask (112),
(V) deposition of a second insulating material (154) between the first strips (153),
(VI) successive depositions solely on the second material (154) of a third conductive material (156), of a fourth insulating material (160) and a fifth conductive material (162), the height of the stack of the second, third, fourth and fifth materials being close to that of the first strips (153),
(VII) production of the second mask (126),
(VIII) elimination of the regions of the fifth, fourth, third and possibly second materials not masked by the second mask, thus forming second overhanging strips (58-128) parallel to a second direction (X) perpendicular to the first direction,
(IX) production of sources (52) and drains (54) by a first doping of the substrate (56) having a reverse conductivity to that of the substrate,
(X) elimination of the second mask (126),
(XI) production of insulating spacers (131) on either side of the second strips (58-128) and joined to the latter,
(XII) production of second conductor lines (78) in the spaces defined between the spacers (131), the height of the second lines being less than that of the second strips and the spacers,
(XIII) covering the second conductor lines (78) by a sixth insulating material (138) level with the top of the second strips (58-128),
(XIV) deposition of a layer of a seventh conductive material (142) over the entire structure obtained,
(XV) production of the third mask (144),
(XVI) elimination of the regions of the seventh material not masked by the third mask, thus forming the first conductor lines (76) and,
(XVII) elimination of the third mask (144).

22. Process according to claim 13 or 14, applied to the manufacture of a memory cell integrated on a semiconductor substrate (56) having (a) a plurality of memory points (50) electrically insulated from one another by lateral insulations (118, 125, 148, 153), each memory point consisting of a transistor incorporating inter alia at least one first (62, 164, 156a) and one second (66, 168, 162a) gates in stacked and reciprocally insulated form, characterized in that it comprises the following stages:
(A) deposition of a layer (152) of a first insulating material on the complete substrate (56) for forming the lateral insulations,
(B) production of the second mask (126),
(C) elimination of the regions of the first material not masked by the second mask (126), thus forming the first overhanging strips (201) parallel to a first direction (X),
(D) elimination of the second mask (126),
(E) deposition of an intermediate material (204) between the first strips (201) which can be selectively etched with respect to the first material,
(F) production of the first mask (112),
(G) elimination of the regions of the first material not masked by the first mask (112), thus forming second overhanging strips (201a-204) parallel to a second direction (Y),
(H) elimination of the first mask (112),
(I) deposition of a second insulating material (206) between the second strips (201a-204),
(J) successive depositions between the second strips of a third conductive material (156), a fourth insulating material (160) and a fifth conductive material (162), the height of the stack of the second, third, fourth and fifth materials being close to that of the second strips,
(K) elimination of the intermediate material (204),
(L) production of source (52) and drains (54) by a first doping of the substrate (56) with a reverse conductivity to that of the substrate,
(M) production of insulating spacers (131) on either side of the second strips (201a-204) and joined to the latter,
(N) production of second conductor lines (78) in the spaces defined between the spacers (131), the height of the second lines being less than that of the second strips and the spacers,
(O) covering the second conductor lines (78) by a sixth insulating material (138) level with the top of the second strips,
(P) deposition of a layer of a seventh conductive material (142) on the entire structure obtained,
(Q) production of the third mask (144),
(R) elimination of the regions of the seventh material not masked by the third mask, thus forming the first conductor lines (76) and,
(S) elimination of the third mask (144).

23. Manufacturing process according to claim 20, 21 or 22, characterized in that there is a second doping of the substrate (56) having the same type of conductivity as that of the substrate between the depositions of the second and third materials.

24. Manufacturing process according to any one of the claims 20 to 23, characterized in that, as the substrate (156) is made from silicon, the second material (154) is deposited by thermal oxidation of the substrate.

25. Manufacturing process according to any one of the claims 21 to 24, characterized in that, as the third conductive material (156) is silicon, the fourth insulating material (160) is wholly or partly obtained by thermal oxidation of said third material.

26. Manufacturing process according to any one of the claims 21 to 25, characterized in that on the complete structure is deposited a layer of a fifth material (162) and in that said layer is etched until the top of the first strips (153) is exposed, so that the fifth conductive material is only obtained above the second conductive material.

27. Manufacturing process according to any one of the claims 15, 19 to 22, characterized in that, as the substrate is made from silicon and has exposed regions, the stage of producing the second conductor lines (76) comprises the following operations:
deposition on the complete structure of a layer (146) of a tenth material able to form a silicide,
thermal annealing of the assembly in order to react said tenth material directly in contact with the exposed substrate regions in order to locally form a silicide and, elimination of the tenth material which has not reacted with the substrate.

28. Manufacturing process according to any one of the claims 15 to 26, characterized in that the stage of producing the second conductor lines (76) comprises the following operations:
deposition of a layer of at least one eleventh conductive material (134) on the complete structure,
deposition on the entire eleventh material of a third resin layer (136) eliminating the relief of the eleventh material,
optionally heat treatment of the third resin layer (136),
etching the third resin layer (136) so as to only leave behind resin in the hollowed out relief parts of the eleventh material,
elimination of the regions of the eleventh material not covered with resin, and
elimination of the remaining third resin layer (136).

29. Manufacturing process according to claim 28, characterized in that the eleventh material layer is formed from a TiW layer covered with an aluminium layer.

30. Manufacturing process according to claim 28, characterized in that the eleventh material layer is formed by a titanium layer.

31. Manufacturing process according to any one of the claims 15 to 30, characterized in that beneath the lateral insulations (118, 125, 148, 153) is performed a third doping of the substrate having the same type of conductivity as the substrate (56).

## Patentansprüche

1. Integrierter Schaltkreis auf einem Halbleitersubstrat (56), enthaltend (a) einen Aufbau von Transistoren (50), elektrisch und seitlich voneinander isoliert durch Seitenisolierungen, wobei jeder Transitor eine erste Aufeinanderschichtung (58, 258) von Materialien umfaßt, gebildet aus einem ersten Isolator (60, 102, 154), in Kontakt mit dem Substrat, und wenigstens einem Gate (62, 164, 218, 262, 156a), in Kontakt mit dem ersten Isolator, einer Source (52) und einem Drain (54), ausgebildet in dem Substrat (56) beiderseits der Aufeinanderschichtung (58, 258), und einem Kanal, in dem Substrat befindlich, unter der genannten Aufeinanderschichtung, dessen Länge ausgerichtet ist entsprechend einer ersten Richtung (Y), von der Source zum Drain verlaufend, (b) erste Leitungen (76), deren Längsachse parallel ist zu einer zweiten Richtung, um erste elektrische Signale einzuspeisen in die genannten Aufeinanderschichtungen (58, 258), (c) zweite Leitungen (78), deren Längsachse parallel ist zu einer dritten Richtung (X), um zweite elektrischen Signale einzuspeisen in die Drains (54) und (d) dritte Leitungen (80), deren Längsachse parallel ist zu der dritten Richtung, um dritte elektrische Signale in die Sources (52) einzuspeisen, wobei die zweite Richtung zusammenfällt mit der ersten Richtung (Y), und die dritte Richtung (X) senkrecht ist zur ersten Richtung,
dadurch **gekennzeichnet**,
daß die zweiten und die dritten Leitungen direkt auf den Drains bzw. den Sources ausgeführt sind.

2. Integrierte Schaltung nach Anspruch 1, dadurch gekennzeichnet, daß die Gates und die ersten Leitungen unabhängig voneinander und aus unterschiedlichen Materialien hergestellt sind.

3. Integrierte Schaltung nach Anspruch 1 oder 2, dadurch gekennzeichnet, daß die ersten Leitungen in Metall ausgeführt sind.

4. Integrierte Schaltung nach Anspruch 1, dadurch gekennzeichnet, daß die ersten Leitungen (76, 276) in Aluminium ausgeführt sind.

5. Integrierte Schaltung nach einem der Ansprüche 1 bis 4, dadurch gekennzeichnet, daß die zweiten und dritten Leitungen (78, 80) in Metall oder dem Silicid eines hitzebeständigen Metalls ausgeführt sind.

6. Integrierte Speicherzelle auf einem Halbleitersubstrat (56), enthaltend (a) einen Aufbau von Speicherplätzen (50), elektrisch und seitlich voneinander isoliert durch seitliche Isolationen, dadurch gekennzeichnet, daß sie aus einem integrierten Schaltkreis nach einem der Ansprüche 1 bis 4 besteht, bei dem die Transistoren die genannten Speicherplätze bilden, und die Materialschichten dieser Transistoren ein erstes (62, 164, 156a) und ein zweites (66, 168, 162a) Gate umfassen, voneinander getrennt durch einen zweiten Isolator (64, 160), wobei das erste Gate Kontakt hat mit dem ersten Isolator.

7. Speicherzelle nach Anspruch 6, dadurch gekennzeichnet, daß die zweiten und dritten Leitungen (78, 80) in Metall oder dem Silicid eines hitzebeständigen Metalls ausgeführt sind.

8. Speicherzelle nach Anspruch 6 oder 7, dadurch gekennzeichnet, daß das erste (62, 164) und das zweite (66, 168) Gate der Speicherplätze die gleiche Breite und die gleiche Länge haben.

9. Speicherzelle nach einem der Ansprüche 6 bis 8, dadurch gekennzeichnet, daß das erste (62, 164) und das zweite Gate (66, 168) der Speicherplätze sich nicht ausbreiten über die Seitenisolationen (118, 125, 148, 153), die vorgesehen sind, die Speicherplätze untereinander elektrisch zu isolieren.

10. Speicherzelle nach einem der Ansprüche 6 bis 9, dadurch gekennzeichnet, daß das erste Gate (164) wenigstens in einem Parallelschnitt zur dritten Richtung (X) die Form eines U aufweist.

11. Speicherzelle nach Anspruch 10, dadurch gekennzeichnet, daß das erste Gate (156a) in einem Parallelschnitt zur dritten Richtung (X) und in einem Parallelschnitt zur zweiten Richtung (Y) die Form eines U aufweist.

12. Speicherzelle nach einem der Ansprüche 6 bis 11, dadurch gekennzeichnet, daß sie außerdem zweite Aufeinanderschichtungen (82) aus Materialien umfaßt, jedes gebildet aus einem dritten Isolator (84), in Kontakt mit dem Substrat (56), einem vierten (86) und fünften (90) Leitermaterial, voneinander getrennt durch ein sechstes Isoliermaterial (88), wobei das vierte Material in Kontakt ist mit dem dritten Isolator, wobei jede zweite Aufeinanderschichtung (82) angeordnet ist zwischen zwei Speicherplätzen (50a, 50b) entsprechend einer ersten Richtung (Y), wobei ein Isolierungseinschnitt (92), ausgebildet in dem Substat (56), vorgesehen ist unter jeder zweiten Aufeinanderschichtung (82).

13. Herstellungsverfahren eines integrierten Schaltkreises nach Anspruch 1, dadurch gekennzeichnet, daß es nur drei lithographische Abdeckebenen (112, 126, 144) aufweist, eine erste Abdeckmaske (112), um simultan die Breite der Kanäle sowie die Länge der Seitenisolierungen zu definieren, eine zweite Abdeckmaske (126), um simultan die Breite der Seitenisolierungen sowie die Länge der Kanäle zu definieren, und eine dritte Abdeckmaske (144), um die ersten Leitungen (76) zu definieren, und dadurch, daß die zweiten und dritten Leitungen direkt auf den Drains bzw. den Sources ausgeführt sind.

14. Herstellungsverfahren nach Anspruch 13, dadurch gekennzeichnet, daß die erste (112), zweite (126) und dritte (144) der Abdeckmasken jeweils gebildet wird durch geradlinige Bänder (111, 127, 145) von konstanter Breite und gleichem Abstand, wobei die Bänder (111, 145) der ersten und dritten Abdeckmaske senkrecht sind zu denen der zweiten Abdeckmaske.

15. Herstellungsverfahren nach Anspruch 13 oder 14, dadurch gekennzeichnet, daß es folgende Fertigungsschritte enthält:
(1) aufeinanderfolgende Niederschläge einer Schicht (102) eines ersten, isolierenden Materials, und einer Schicht (218) eines zweiten, leitenden Materials auf dem Substrat (56),
(2) Herstellung einer ersten Abdeckmaske (112),
(3) Beseitigung der durch die erste Abdeckmaske nicht abgedeckten Bereiche des zweiten und eventuell ersten Materials, somit erste überstehende Bänder (113) bildend, parallel zu einer ersten Richtung (Y),
(4) Beseitigung der ersten Abdeckmaske (112),
(5) Füllung der durch die ersten Bänder (113) begrenzten Räume durch ein drittes, isolierendes Material (118, 122, 148), die seitlichen Isolierungen bildend,
(6) Herstellung der zweiten Abdeckmaske (126),
(7) Beseitigung der durch die zweite Maske nicht abgedeckten Bereiche des dritten, zweiten und eventuell ersten Materials, somit zweite überstehende Bänder (58-128) bildend, parallel zu einer zweiten Richtung (X), senkrecht zu der ersten Richtung,
(8) Herstellung der Sources (52) und Drains (54) durch eine erste Dotierung des Substrats (56) mit einer Konduktivität des inversen Typs bezüglich der des Substrats,
(9) Beseitigung der zweiten Maske (126),
(10) Herstellung von isolierenden Zwischenlagen (131) beiderseits der zweiten Bänder (58-128), angefügt an diese zweiten Bänder,
(11) Herstellung der zweiten Leitungen (78) in den durch die Zwischenschichten (131) begrenzten Räumen, wobei die Höhe der zweiten Leitungen geringer ist als die der zweiten Bänder und der Zwischenlagen,
(12) Abdeckung der zweiten Leitungen (78) durch ein viertes, isolierendes Material (138), die Oberseite der zweiten Bänder (58-128) versenkend,
(13) Niederschlag einer Schicht aus einem fünften, leitenden Material (142) auf der gesamten entstandenen Struktur,
(14) Herstellung der dritten Abdeckmaske (144),
(15) Beseitigung der durch die dritte Abdeckmaske nicht abgedeckten Bereiche, somit die ersten Leitungen (76) bildend, und
(16) Beseitigung der dritten Abdeckmaske (144).

16. Herstellungsverfahren nach Anspruch 15, dadurch gekennzeichnet, daß man eine zweite Dotierung des Substrats (56) durchführt, die denselben Konduktivitätstyp aufweist wie das Substrat, nach Niederschlag des ersten Materials, um die Dotierung (101) der Kanäle zu definieren.

17. Herstellungsverfahren nach Anspruch 15 oder 16, dadurch gekennzeichnet, daß man im Laufe des Fertigungsschritts (1) eine Schicht (110) eines sechsten, isolierenden Materials auf der Schicht des zweiten (218) Materials niederschlägt, und dadurch, daß diese Schicht des sechsten Materials während der Fertigungsschritte (3) und (7) geätzt wird.

18. Herstellungsverfahren nach Anspruch 17, dadurch gekennzeichnet, daß man zwischen den Fertigungsschritten (4) und (5) die geätzten Oberseiten und Flanken der ersten Bänder (113) mit einem siebten, isolierenden Material (116) bedeckt, und dadurch, daß man das zwischen den geätzten Flanken befindliche Substrat (56) thermisch oxidiert, wobei das Substrat aus Silizium hergestellt ist.

19. Herstellungsverfahren nach Anspruch 13 oder 14, angewandt für die Herstellung einer integrierten Speicherzelle auf einem Halbleitersubstrat (56), umfassend (a) einen Aufbau Speicherzellen, elektrisch voneinander isoliert durch seitliche Isolationen (118, 125, 148, 153), wobei jede Speicherstelle aus einem Transistor besteht, der unter anderem wenigstens ein erstes (62, 164, 156a) und ein zweites (66, 168, 162a) aufeinandergeschichteter Gates enthält, voneinander isoliert, dadurch gekennzeichnet, daß es folgende Fertigungsschritte umfaßt:
(1) aufeinanderfolgende Niederschläge auf dem Substrat (56) einer Schicht (102) eines ersten, isolierenden Materials und einer Schicht (104) eines zweiten, leitenden Materials, einer Schicht (106) eines dritten, isolierenden Materials, und einer Schicht (108) eines vierten, leitenden Materials,
(2) Herstellung der ersten Abdeckmaske (112),
(3) Beseitigen der nicht durch die erste Maske abgedeckten Bereiche des vierten, dritten, zweiten und eventuell ersten Materials, somit erste überstehende Bänder (113) bildend, parallel zu einer ersten Richtung (Y),
(4) Beseitigung der ersten Maske (112),
(5) Füllung der zwischen den ersten Bändern (113) begrenzten Räume durch ein fünftes, isolierendes Material (118, 122, 148), die seitlichen Isolierungen bildend,
(6) Herstellung der zweiten Abdeckmaske (126),
(7) Beseitigung der durch die zweite Maske nicht abgedeckten Bereiche des fünften, vierten, dritten, zweiten und eventuell ersten Materials, somit zweite überstehende Bänder (58-128) bildend, parallel zu einer zweiten Richtung (X), senkrecht zu der ersten Richtung,
(8) Herstellung der Sources (52) und Drains (54) durch eine erste Dotierung des Substrats (56) mit einer Konduktivität des inversen Typs bezüglich des Substrats,
(9) Beseitigung der zweiten Abdeckmaske (126),
(10) Herstellung von isolierenden Zwischenlagen (131) beiderseits der zweiten Bänder (58-128), angefügt an diese zweiten Bänder,
(11) Herstellung der zweiten Leitungen (78) in den durch die Zwischenlagen (131) begrenzten Räumen, wobei die Höhe der zweiten Leitungen geringer ist als die der zweiten Bänder und der Zwischenlagen,
(12) Abdeckung der zweiten Leitungen (78) durch ein sechstes, isolierendes Material (138), die Oberseiten der zweiten Bänder (58-128) versenkend,
(13) Niederschlag einer Schicht eines sechsten, leitenden Materials (142) auf der gesamten entstandenen Struktur,
(14) Herstellung der dritten Abdeckmaske (144),
(15) Beseitigung der nicht durch die dritte Maske abgedeckten Bereiche des siebten Materials, somit die ersten Leitungen (76) bildend und,
(16) Beseitigung der dritten Maske (144).

20. Verfahren nach Anspruch 13 oder 14, dadurch gekennzeichnet, daß es die folgenden Fertigungsschritte umfaßt:
(I) Niederschlag einer Schicht (152) eines ersten, isolierenden Materials auf der Gesamtheit des Substrats (56), um die seitlichen Isolationen zu bilden,
(II) Herstellung der ersten Abdeckmaske (112),
(III) Beseitigung der durch die erste Maske (112) nicht abgedeckten Bereiche des ersten Materials, somit erste überstehende Bänder (153) bildend, parallel zu einer ersten Richtung (Y),
(IV) Beseitigung der ersten Abdeckmaske (112),
(V) Niederschlag eines zweiten, isolierenden Materials (154) zwischen den ersten Bändern (153),
(VI) Niederschläge nur auf dem zweiten Material (154) eines dritten, leitenden Materials (262), wobei die Höhe der Aufeinanderschichtung des zweiten und des dritten Materials der der ersten Bänder (153) nahekommt,
(VII) Herstellung der zweiten Abdeckmaske (126),
(VIII) Beseitigung der durch die zweite Maske (126) nicht abgedeckten Bereiche des dritten und eventuell zweiten Materials, somit zweite überstehende Bänder (58-128) bildend, parallel zu einer zweiten Richtung (X), senkrecht zu der ersten Richtung,
(IX) Herstellung der Sources (52) und der Drains (54) durch eine erste Dotierung des Substrats (56) mit einer Konduktivität des inversen Typs bezüglich der des Substrats,
(X) Beseitigung der zweiten Abdeckmaske (126),
(XI) Herstellung von isolierenden Zwischenlagen (131) beiderseits der zweiten Bänder (58-128), angefügt an diese zweiten Bänder,
(XII) Herstellung der zweiten Leitungen (78) in den durch die Zwischenlagen (131) begrenzten Räumen, wobei die Höhe der zweiten Leitungen geringer ist als die der zweiten Bänder und der Zwischenlagen,
(XIII) Abdeckung der zweiten Leitungen (78) durch ein viertes, isolierendes Material (138), die Oberseiten der zweiten Bänder (58-128) versenkend,
(XIV) Niederschlag einer Schicht des fünften, leitenden Materials (142) auf der gesamten erhaltenen Struktur,
(XV) Herstellung der dritten Abdeckmaske (144),
(XVI) Beseitigung der durch die dritte Maske (144) nicht abgedeckten Bereiche, somit die ersten Leitungen (76) bildend, und
(XVII) Beseitigung der dritten Maske (144).

21. Verfahren nach Anspruch 13 oder 14, angewandt bei der Herstellung einer integrierten Speichzelle auf einem Substrat (56), enthaltend (a) einen Aufbau Speicherplätze (50), elektrisch voneinander getrennt durch seitliche Isolierungen (118, 125, 148, 153), wobei jeder Speicherplatz aus einem Transistor besteht, enthaltend unter anderem wenigstens ein erstes Gate (62, 164, 156a) und ein zweites Gate (66, 168, 162a), aufeinandergeschichtet, voneinander isoliert, dadurch gekennzeichnet, daß es die folgenden Fertigungsschritte umfaßt:
(I) Niederschlag einer Schicht (152) eines ersten, isolierenden Materials auf der Gesamtheit des Substrats (56), um die seitlichen Isolationen zu bilden,
(II) Herstellung der ersten Abdeckmaske (112),
(III) Beseitigung der durch die erste Maske (112) nicht abgedeckten Bereiche des ersten Materials, somit erste überstehende Bänder (153) bildend, parallel zu einer ersten Richtung (Y),
(IV) Beseitigung der ersten Abdeckmaske (112),
(V) Niederschlag eines zweiten, isolierenden Materials (154) zwischen den ersten Bändern (153),
(VI) aufeinanderfolgende Niederschläge nur auf dem zweiten Material (154) eines dritten, leitenden Materials (156), eines vierten, isolierenden Materials (160), eines fünften, leitenden Materials (162), wobei die Höhe der Aufeinanderschichtung des zweiten, dritten vierten und fünften Materials der der ersten Bänder (153) nahekommt,
(VII) Herstellung der zweiten Abdeckmaske (126),
(VIII) Beseitigung der durch die zweite Maske (126) nicht abgedeckten Bereiche des dritten und eventuell zweiten Materials, somit zweite überstehende Bänder (58-128) bildend, parallel zu einer zweiten Richtung (X), senkrecht zu der ersten Richtung,
(IX) Herstellung der Sources (52) und der Drains (54) durch eine erste Dotierung des Substrats (56) mit einer Konduktivität des inversen Typs bezüglich der des Substrats,
(X) Beseitigung der zweiten Abdeckmaske (126),
(XI) Herstellung von isolierenden Zwischenlagen (131) beiderseits der zweiten Bänder (58-128), angefügt an diese zweiten Bänder,
(XII) Herstellung der zweiten Leitungen (78) in den durch die Zwischenlagen (131) begrenzten Räumen, wobei die Höhe der zweiten Leitungen geringer ist als die der zweiten Bänder und der Zwischenlagen,
(XIII) Abdeckung der zweiten Leitungen (78) durch ein sechstes, isolierendes Material (138), die Oberseiten der zweiten Bänder (58-128) versenkend,
(XIV) Niederschlag einer Schicht eines siebten, leitenden Materials (142) auf der gesamten erhaltenen Struktur,
(XV) Herstellung der dritten Abdeckmaske (144),
(XVI) Beseitigung der durch die dritte Maske (144) nicht abgedeckten Bereiche, somit die ersten Leitungen (76) bildend, und
(XVII) Beseitigung der dritten Maske (144).

22. Verfahren nach Anspruch 13 oder 14, angewandt bei der Herstellung einer integrierten Speichzelle auf einem Substrat (56), enthaltend (a) einen Aufbau Speicherplätze (50), elektrisch voneinander getrennt durch seitliche Isolierungen (118, 125, 148, 153), wobei jeder Speicherplatz aus einem Transistor besteht, enthaltend unter anderem wenigstens ein erstes Gate (62, 164, 156a) und ein zweites Gate (66, 168, 162a), aufeinandergeschichtet, voneinander isoliert, dadurch gekennzeichnet, daß es die folgenden Fertigungsschritte umfaßt:
(A) Niederschlag einer Schicht (152) eines ersten, isolierenden Materials auf der Gesamtheit des Substrats (56), um die seitlichen Isolationen zu bilden,
(B) Herstellung der ersten Abdeckmaske (126),
(C) Beseitigung der durch die erste Maske (126) nicht abgedeckten Bereiche des ersten Materials, somit erste überstehende Bänder (201) bildend, parallel zu einer ersten Richtung (X),
(D) Beseitigung der ersten Abdeckmaske (126),
(E) Niederschlag eines Zwischenmaterials (204) zwischen den ersten Bändern (201), das man selektiv gravieren kann bezüglich des ersten Materials,
(F) Herstellung der ersten Maske (112)
(G) Beseitigung der durch die erste Maske (112) nicht abgedeckten Bereiche, somit zweite überstehende Bänder (201a-204) bildend, parallel zu einer zweiten Richtung (Y),
(H) Beseitigung der ersten Maske (112),
(I) Niederschlag eines zweiten isolierenden Materials (206) zwischen den zweiten Bändern (201a-204),
(J) aufeinanderfolgende Niederschläge zwischen den zweiten Bändern eines dritten, leitenden Materials (156), eines vierten, isolierenden Materials (160), eines fünften, leitenden Materials (162), wobei die Höhe der Aufeinanderschichtung des zweiten , dritten, vierten und fünften Materials der Höhe der zweiten Bänder nahekommt,
(K) Beseitigung des Zwischenmaterials (204),
(L) Herstellung der Sources (52) und der Drains (54) durch eine erste Dotierung des Substrats (56) mit einer Konduktivität des inversen Typs bezüglich der des Substrats,
(M) Herstellung von isolierenden Zwischenlagen (131) beiderseits der zweiten Bänder (201a-204), angefügt an diese zweiten Bänder,
(N) Herstellung der zweiten Leitungen (78) in den durch die Zwischenlagen (131) begrenzten Räumen, wobei die Höhe der zweiten Leitungen geringer ist als die der zweiten Bänder und der Zwischenlagen,
(O) Abdeckung der zweiten Leitungen (78) durch ein sechstes, isolierendes Material (138), die Oberseiten der zweiten Bänder versenkend,
(P) Niederschlag einer Schicht des siebten, leitenden Materials (142) auf der gesamten erhaltenen Struktur,
(Q) Herstellung der dritten Abdeckmaske (144),
(R) Beseitigung der durch die dritte Maske (144) nicht abgedeckten Bereiche, somit die ersten Leitungen (76) bildend, und
(S) Beseitigung der dritten Maske (144).

23. Herstellungsverfahren nach Anspruch 20, 21 oder 22, dadurch gekennzeichnet, daß man eine zweite Dotierung des Substrats (56) durchführt mit dem gleichen Konduktivitätstyp wie das Substrat, zwischen den Niederschlägen des zweiten und dritten Materials.

24. Herstellungsverfahren nach einem der Ansprüche 20 bis 23, dadurch gekennzeichnet, daß der Niederschlag des zweiten Materials (154) hergestellt wird durch thermisches Oxidieren des Substrats, wobei das Substrat (56) aus Silizium ist.

25. Herstellungsverfahren nach einem der Ansprüche 21 bis 24, dadurch gekennzeichnet, daß das vierte, isolierende Material (160) erhalten wird, ganz oder teilweise, durch thermisches Oxidieren des dritten, leitende Material (156), wobei das dritte Material aus Silizium ist.

26. Herstellungsverfahren nach einem der Ansprüche 21 bis 25, dadurch gekennzeichnet, daß man auf man auf der Gesamtheit der Struktur eine Schicht eines fünften Materials (162) niederschlägt, und dadurch, daß man eine Ätzung dieser Schicht durchführt, bis zum Freiätzung der Oberseiten der ersten Bänder (153), um fünftes, leitendes Material nur über dem zweiten Material zu erhalten.

27. Herstellungsverfahren nach einem der Ansprüche 15, 19 bis 22, dadurch gekennzeichnet, daß der Fertigungsschritt der Herstellung der zweiten Leitungen (76), wobei das Substrat (56) aus Silizium hergestellt ist und unbestückte Bereiche aufweist, folgende Operationen umfaßt:
- Niederschlag einer Schicht (146) eines zehnten Materials, geeignet ein Silicid zu bilden, auf der gesamten Struktur,
- Thermische Behandlung des Aufbaus, um dieses zehnte Material, direkt in Kontakt mit den unbestückten Bereichen des Substrats, eine Reaktion eingehen zu lassen, um örtlich ein Silicid zu bilden, und
- Beseitigung des zehnten Materials, das nicht reagiert hat mit dem Substrat.

28. Herstellungsverfahren nach einem der Ansprüche 15 bis 26, dadurch gekennzeichnet, daß der Fertigungsschritt zur Herstellung der zweiten Leitungen (76) folgende Operationen umfaßt:
- Niederschlag einer Schicht von wenigstens einem elften, leitenden Material (132, 134) auf der gesamten Struktur,
- Niederschlag, auf dem ganzen elften Materials, einer dritten Schicht (136) aus Kunstharz, die das Relief des elften Materials zum Verschwinden bringt,
- eventuell thermische Behandlung der dritten Kunstharzschicht (136),
- Ätzung der dritten Kunstharzschicht (136), so daß nur an den vertieften Teilen des Reliefs des elften Materials Kunstharz zurückbleibt,
- Beseitigung der nicht durch Kunstharz abgedeckten Bereiche des elften Materials, und
- Beseitigung des Restes der dritten Kunstharzschicht (136).

29. Herstellungsverfahren nach Anspruch 28, dadurch gekennzeichnet, daß die Schicht aus dem elften Material gebildet wird durch eine TiW-Schicht, abgedeckt durch eine Aluminiumschicht.

30. Herstellungsverfahren nach Anspruch 28, dadurch gekennzeichnet, daß die Schicht des elften Materials gebildet wird durch eine Titanschicht.

31. Herstellungsverfahren nach einem der Ansprüche 15 bis 30, dadurch gekennzeichnet, daß man unter den seitlichen Isolationen (118, 125, 148, 153) eine dritte Dotierung des Substrats durchführt, die den gleichen Konduktivitätstyp aufweist, wie der des Substrats (56).
